# EUROPÄISCHE PATENTSCHRIFT

(11) **EP 2 223 397 B1**
(45) Veröffentlichungstag und Bekanntmachung des Hinweises auf die Patenterteilung: **30.01.2019**
(21) Anmeldenummer: 08865674.9
(22) Anmeldetag: 17.12.2008
(51) Int. Cl.: H01S 5/028, H01S 5/22

(54) **LASERLICHTQUELLE UND VERFAHREN ZUR HERSTELLUNG EINER LASERLICHTQUELLE**
LASER LIGHT SOURCE AND METHOD FOR PRODUCING A LASER LIGHT SOURCE
SOURCE DE LUMIÈRE LASER ET PROCÉDÉ DE FABRICATION D'UNE SOURCE DE LUMIÈRE LASER

(30) Priorität: 21.12.2007 DE 102007061923; 06.03.2008 DE 102008012859
(43) Veröffentlichungstag der Anmeldung: 01.09.2010
(73) Patentinhaber: OSRAM Opto Semiconductors GmbH, 93055 Regensburg (DE)
(72) Erfinder: LELL, Alfred, 93142 Maxhütte - Haidhof (DE); EICHLER, Christoph, 93105 Tegernheim (DE); SCHMID, Wolfgang, 93053 Regensburg (DE); TAUTZ, Sönke, 93105 Tegernheim (DE); REILL, Wolfgang, 93080 Pentling (DE); DINI, Dimitri, 93059 Regensburg (DE)
(74) Vertreter: Epping - Hermann - Fischer
(86) Internationale Anmeldenummer: PCT/DE2008/002127
(87) Internationale Veröffentlichungsnummer: WO 2009/080012

(56) Entgegenhaltungen:
- EP-A- 1 508 946
- US-A- 5 721 752
- US-A1- 2003 165 170
- US-A1- 2004 213 315
- US-A1- 2005 040 410
- US-A1- 2005 286 583
- US-A1- 2007 278 475
- STREIFER W ET AL: "REDUCTION OF GAAS DIODE LASER SPONTANEOUS EMISSION" APPLIED PHYSICS LETTERS, AIP, AMERICAN INSTITUTE OF PHYSICS, MELVILLE, NY, US, Bd. 37, Nr. 1, 1. Juli 1980 (1980-07-01), Seiten 10-12, XP000706305 ISSN: 0003-6951
- KERPS: "Suppression of side lobes in hte far field of AlGaAs stripe lasers by a Te facet coating" APPLIED OPTICS, 1979, XP001649494

## Beschreibung

Diese Patentanmeldung beansprucht die Prioritäten der deutschen Patentanmeldung 10 2007 061 923.7 und der deutschen Patentanmeldung 10 2008 012 859.7, deren Offenbarungsgehalte hiermit durch Rückbezug aufgenommen werden.

Im Folgenden werden eine Laserlichtquelle und ein Verfahren zur Herstellung einer Laserlichtquelle angegeben.

Aufgrund des technischen Fortschritts bei Halbleiterlasern werden zahlreiche neue Anwendungen möglich gemacht. Viele dieser Anwendungen erfordern Laser, die in einer transversalen Grundmode betrieben werden und die eine hervorragende Strahlqualität aufweisen.

Die Druckschrift W. Streifer et al.: "Reduction of GaAs diode laser spontaneous emission", Applied Physics Letters 37, 10-12, 1980 offenbart ein Verfahren zur Herstellung eines kantenemittierenden GaAs-Halbleiterlasers mit einem Filter, der die Abstrahlung spontan emittierter Strahlung verringert. Dazu wird auf die Frontfacette des Halbleiterlasers eine 500 Ä dicke Tellurschicht aufgebracht. Durch gepulste Inbetriebnahme des Lasers schmilzt die Tellurschicht im Bereich des Modenzentrums, so dass eine Öffnung im Bereich der Austrittsfläche der Lasermode erzeugt wird. Anschließend wird auf die Tellurschicht mit der erzeugten Öffnung eine Aluminiumoxidschicht aufgebracht.

Die Druckschrift D. Kerps: "Suppression of side lobes in the far field of AlGaAs stripe lasers by a Te facet coating", Applied Physics Letters 35, 372-373, 1979 offenbart ein entsprechendes Verfahren für einen AlGaAs-Halbleiterlaser.

Die Druckschrift US 5,721,752 A beschreibt einen Halbleiterlaser, der auf einer Front- oder Rückseitenfacette einen sättigbaren Absorber aufweist, um einen pulsierenden Laserbetrieb mit guter Lasercharakteristik zu erreichen.

Eine Aufgabe zumindest einer Ausführungsform ist es, eine Laserlichtquelle mit einer Halbleiterschichtenfolge anzugeben.

Diese Aufgabe wird durch einen Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen aus der nachfolgenden Beschreibung und den Zeichnungen hervor.

Hier und im Folgenden kann "Licht" oder "elektromagnetische Strahlung" gleichermaßen insbesondere elektromagnetische Strahlung mit zumindest einer Wellenlänge oder einem Wellenlängenbereich aus einem infraroten bis ultravioletten Wellenlängenbereich bedeuten. Insbesondere können der erste und der zweite Wellenlängenbereich dabei einen ultravioletten und/oder sichtbaren, also einen roten bis blauen Wellenlängenbereich mit einer oder mehreren Wellenlängen zwischen etwa 350 nm und etwa 700 nm, umfassen.

Die kohärente erste elektromagnetische Strahlung kann dabei insbesondere durch ein erstes Spektrum im ersten Wellenlängenbereich mit einer spektralen Breite von weniger als 10 nm und bevorzugt weniger als 5 nm charakterisiert sein und eine große Kohärenzlänge aufweisen. Das kann insbesondere bedeuten, dass die kohärente erste elektromagnetische Strahlung eine Kohärenzlänge in einer Größenordnung von Metern bis zu einer Größenordnung von hundert Metern oder mehr aufweist. Dadurch kann es möglich sein, dass die kohärente erste elektromagnetische Strahlung in einen Strahl mit geringer Divergenz und geringem Strahlquerschnitt kollimierbar und/oder fokussierbar sein kann. Dazu kann der Strahlungsauskoppelfläche der Halbleiterschichtenfolge eine Kollimations- oder Fokussierungsoptik wie etwa eine anamorphotische Linse, etwa eine Zylinderlinse, nachgeordnet sein, mit der die kohärente erste elektromagnetische Strahlung zu einem Strahlenbündel kollimiert und/oder fokussiert werden kann, dass Strahleigenschaft ähnlich einem idealen Gaußschen Strahlenbündel aufweisen kann.

Während die kohärente erste elektromagnetische Strahlung im aktiven Bereich im Betrieb der Laserlichtquelle durch stimulierte Emission mit einer festen Phasenbeziehung und einem eng begrenzten Raumwinkelbereich erzeugt werden kann, kann die inkohärente zweite elektromagnetische Strahlung beispielsweise durch gleichzeitig dazu stattfindende spontane Emission erzeugt werden. Im Gegensatz zu elektromagnetischer Strahlung aus stimulierter Emission weist spontan emittierte elektromagnetische Strahlung keine Richtungsabhängigkeit auf und kann daher isotrop erzeugt werden. Dadurch kann die inkohärente zweite elektromagnetische Strahlung in einem größeren Winkelbereich als die kohärente erste elektromagnetische Strahlung von der Strahlungsauskoppelfläche und zusätzlich zur Abstrahlung vom ersten Teilbereich auch vom zweiten Teilbereich der Strahlungsauskoppelfläche abgestrahlt werden. Weiterhin weist der zweite Wellenlängenbereich der inkohärenten zweiten elektromagnetischen Strahlung eine größere spektrale Verteilung als der erste Wellenlängenbereich der kohärenten ersten elektromagnetischen Strahlung auf.

Daher hat die inkohärente zweite elektromagnetische Strahlung im Vergleich zur kohärenten ersten elektromagnetischen Strahlung andere Abbildungseigenschaften und weist insbesondere eine geringere Fokussierbarkeit und/oder Kollimierbarkeit auf. Dadurch kann es möglich sein, dass die Strahlqualität einer elektromagnetischen Strahlung, die die kohärente erste elektromagnetische Strahlung und die inkohärente zweite elektromagnetische Strahlung umfasst, im Gegensatz zur Strahlqualität der kohärenten ersten elektromagnetischen Strahlung alleine erheblich verschlechtert wird.

Beispielsweise kann sich die inkohärente zweite elektromagnetische Strahlung bei Laserprojektionsanwendungen für einen externen Beobachter äußerst störend auswirken. Bei Laserprojektionsanwendungen kann beispielsweise ein durch eine Laserlichtquelle erzeugter Lichtpunkt beispielsweise über einen oder mehrere bewegbare Ablenkspiegel über einen Oberflächenbereich bewegt und in seiner Intensität moduliert werden. Wird der Lichtpunkt beispielsweise 50 oder 60 mal pro Sekunde über den gesamten Oberflächenbereich bewegt, so kann auf der Oberfläche ein bildhafter Leuchteindruck für einen externen Beobachter erzeugt werden, da das menschliche Auge den einzelnen sich bewegenden Lichtpunkt zeitlich nicht mehr auflösen kann und stattdessen den beleuchteten Oberflächenbereich wahrnimmt. Für mehrfarbige Projektionsanwendungen können auch mehrere Laserlichtquellen mit verschiedenen Wellenlängenbereichen, etwa einem roten, grünen und blauen Wellenlängenbereich, nebeneinander eingesetzt werden. Um eine möglichst scharfe Darstellung und einen hohen Kontrast bei der Projektion zu erreichen, sollte der Lichtpunkt dabei bevorzugt nur durch die Abbildung der kohärenten ersten elektromagnetischen Strahlung auf der Oberfläche gebildet sein. Da das menschliche Auge bezüglich der Wahrnehmung von Lichtintensitäten einen hohen Dynamikbereich aufweist, kann die inkohärente zweite elektromagnetische Strahlung zu einem Leuchteindruck mit einer unscharfen Abbildung und einem verschlechtertem Kontrastverhältnis führen.

Dadurch, dass die hier beschriebene Laserlichtquelle eine Filterstruktur umfasst, die die vom aktiven Bereich abgestrahlte inkohärente zweite elektromagnetische Strahlung entlang der Abstrahlrichtung zumindest teilweise abschwächt, kann es möglich sein, dass die Strahlqualität der von der Laserlichtquelle abgestrahlten elektromagnetischen Strahlung, beispielsweise messbar in Form der dem Fachmann bekannten Beugungsmaßzahl M², im Vergleich zu herkömmlichen Lasern wesentlich verbessert wird. Insbesondere kann die Filterstruktur geeignet sein, die inkohärente zweite elektromagnetische Strahlung am Austritt aus der Halbleiterschichtenfolge zumindest in Abstrahlrichtung zu hindern, umzulenken oder zu absorbieren.

Weiterhin kann die hier beschriebene Laserlichtquelle mit Vorteil beispielsweise für Datenspeicherungs- oder Druckanwendungen einsetzbar sein, da durch die zumindest teilweise Verringerung der inkohärenten zweiten elektromagnetischen Strahlung in Abstrahlrichtung eine im Vergleich zu herkömmlichen Laserbauelementen höhere Auflösung aufgrund der oben beschriebenen verbesserten Fokussierbarkeit und/oder Kollimierbarkeit der von der Laserlichtquelle abgestrahlten elektromagnetischen Strahlung ermöglicht werden kann. Dadurch kann bei diesen Anwendungen beispielsweise eine höher Speicherdichte bzw. Druckauflösung erreichbar sein.

Weiterhin kann es aufgrund der verbesserten Strahlqualität möglich sein, dass einfache, kostengünstige und kompakte Abbildungsoptiken in Verbindung mit der hier beschriebenen Laserlichtquelle einsetzbar sind.

Die kohärente erste elektromagnetische Strahlung kann eine erste Intensität und die inkohärente zweite elektromagnetische Strahlung kann eine zweite Intensität aufweisen, wobei die erste Intensität mindestens zweimal, bevorzugt mindestens zehnmal und besonders bevorzugt mindestens hundertmal größer als die zweite Intensität sein kann. Die Intensität kann dabei hier und im Folgenden die Energie oder die Leuchtdichte einer elektromagnetischen Strahlung pro Flächeneinheit bedeuten. Insbesondere können die erste und zweite Intensität Intensitäten an der Strahlungsauskoppelfläche bezeichnen.

Die Halbleiterschichtenfolge kann als Epitaxieschichtenfolge oder als strahlungsemittierender Halbleiterchip mit einer Epitaxieschichtenfolge, also als epitaktisch gewachsene Halbleiterschichtenfolge ausgeführt sein. Dabei kann die Halbleiterschichtenfolge beispielsweise auf der Basis von InGaAlN ausgeführt sein. Unter InGaAlN-basierte Halbleiterchips und Halbleiterschichtenfolgen fallen insbesondere solche, bei denen die epitaktisch hergestellte Halbleiterschichtenfolge in der Regel eine Schichtenfolge aus unterschiedlichen Einzelschichten aufweist, die mindestens eine Einzelschicht enthält, die ein Material aus dem III-V-Verbindungshalbleitermaterialsystem InₓAl_{yG}a_{1-x-y}N mit 0 ≤ x ≤ 1, 0 ≤ y ≤ 1 und x + y ≤ 1 aufweist. Halbleiterschichtenfolgen, die zumindest eine aktive Schicht auf Basis auf InGaAlN aufweisen, können beispielsweise bevorzugt elektromagnetische Strahlung in einem ultravioletten bis grünen Wellenlängenbereich emittieren.

Alternativ oder zusätzlich kann die Halbleiterschichtenfolge oder der Halbleiterchip auch auf InGaAlP basieren, das heißt, dass die Halbleiterschichtenfolge unterschiedliche Einzelschichten aufweisen kann, wovon mindestens eine Einzelschicht ein Material aus dem III-V-Verbindungshalbleitermaterialsystem InₓAl_{yG}a_{1-x-y}P mit 0 ≤ x ≤ 1, 0 ≤ y ≤ 1 und x + y ≤ 1 aufweist. Halbleiterschichtenfolgen oder Halbleiterchips, die zumindest eine aktive Schicht auf Basis von InGaAlP aufweisen, können beispielsweise bevorzugt elektromagnetische Strahlung mit einer oder mehreren spektralen Komponenten in einen grünen bis roten Wellenlängenbereich emittieren.

Alternativ oder zusätzlich kann die Halbleiterschichtenfolge oder der Halbleiterchip auch andere III-V-Verbindungshalbleitermaterialsysteme, beispielsweise ein AlGaAs-basiertes Material, oder II-VI-Verbindungshalbleitermaterialsysteme aufweisen. Insbesondere kann eine aktive Schicht, die ein AlGaAs-basiertes Material aufweist, geeignet sein, elektromagnetische Strahlung mit einer oder mehreren spektralen Komponenten in einem roten bis infraroten Wellenlängenbereich zu emittieren.

Die Halbleiterschichtenfolge kann weiterhin ein Substrat aufweisen, auf dem die oben genannten III-V- oder II-VI-Verbindungshalbleitermaterialsystem abgeschieden sind. Das Substrat kann dabei ein Halbleitermaterial, beispielsweise ein oben genanntes Verbindungshalbleitermaterialsystem umfassen. Insbesondere kann das Substrat Saphir, GaAs, GaP, GaN, InP, SiC, Si und/oder Ge umfassen oder aus einem solchen Material sein. Insbesondere kann das Substrat dabei transparent für die kohärente erste elektromagnetische Strahlung und die inkohärente zweite elektromagnetische Strahlung sein.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen. Die Halbleiterschichtenfolge kann neben dem aktiven Bereich weitere funktionale Schichten und funktionelle Bereiche umfassen, etwa p- oder n-dotierte Ladungsträgertransportschichten, also Elektronen- oder Löchertransportschichten, undotierte oder p- oder n-dotierte Confinement-, Mantel- oder Wellenleiterschichten, Barriereschichten, Planarisierungsschichten, Pufferschichten, Schutzschichten und/oder Elektroden sowie Kombinationen daraus. Solche Strukturen den aktiven Bereich oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Darüber hinaus können zusätzliche Schichten, etwa Pufferschichten, Barriereschichten und/oder Schutzschichten auch senkrecht zur Aufwachsrichtung der Halbleiterschichtenfolge beispielsweise um die Halbleiterschichtenfolge herum angeordnet sein, also etwa auf den Seitenflächen der Halbleiterschichtenfolge.

Beispielsweise kann es sich bei der Halbleiterschichtenfolge oder dem Halbleiterchip um eine kantenemittierende Laserdiode handeln. Das kann insbesondere bedeuten, dass die Strahlungsauskoppelfläche durch eine Seitenfläche der Halbleiterschichtenfolge oder des Halbleiterchips gebildet wird, wobei die Strahlungsauskoppelfläche auch eine Seitenfläche des Substrats umfassen kann. Darüber hinaus kann die Strahlungsaustrittsfläche beispielsweise auch eine Mehrzahl von Seitenflächen umfassen. Bevorzugt kann die Halbleiterschichtenfolge dabei eine erste und eine zweite Wellenleiterschicht aufweisen, zwischen denen der aktive Bereich angeordnet ist. Um einen Betrieb der Halbleiterschichtenfolge in einer transversalen Grundmode zu ermöglichen, können Schichten der Halbleiterschichtenfolge, die auf zumindest einer Seite des aktiven Bereichs angeordnet sind, beispielsweise steg- und/oder trapezförmig strukturiert sein. Derartige als Stegwellenleiter, Rippenwellenleiter, "Ridge-Struktur", "Trapezstruktur" oder "tapered structure" bekannte Ausgestaltungen der Halbleiterschichtenfolge sind dem Fachmann bekannt und werden hier nicht weiter ausgeführt.

Alternativ kann es sich bei der Halbleiterschichtenfolge oder dem Halbleiterchip auch um eine vertikal emittierende Laserdiode ("VCSEL") handeln, so dass die Strahlungsauskoppelfläche durch eine Hauptoberfläche der Halbleiterschichtenfolge oder des Halbleiterchips gebildet werden kann.

Weiterhin kann die Laserlichtquelle eine Mehrzahl von Halbleiterschichtenfolgen oder Halbleiterchips oder eine Halbleiterschichtenfolge oder ein Halbleiterchip mit einer Mehrzahl von aktiven Bereichen umfassen. Insbesondere kann die Laserlichtquelle auch als so genannter Breitstreifenlaser ausgeführt sein.

Weiterhin kann es beispielsweise auch möglich sein, dass in einem ersten aktiven Bereich eine elektromagnetische Strahlung erzeugt wird, die in einem zweiten aktiven Bereich beispielsweise durch optisches Pumpen die erste elektromagnetische Strahlung erzeugen kann. Weiterhin kann die erste Strahlungsquelle auch Elemente beispielsweise zur Frequenzmischung oder insbesondere zur Frequenzverdopplung aufweisen. Solche Elemente können in die Halbleiterschichtenfolge integriert, auf der Halbleiterschichtenfolge aufgebracht oder extern zur Halbleiterschichtenfolge angebracht sein. Insbesondere kann die Halbleiterschichtenfolge einen optischen Resonator für die kohärente erste elektromagnetische Strahlung aufweisen. Dieser kann insbesondere einen ersten Spiegel als Strahlungsauskoppelfläche oder auf der Strahlungsauskoppelfläche und einen zweiten Spiegel auf einer der Strahlungsauskoppelfläche gegenüberliegenden Oberfläche der Halbleiterschichtenfolge umfassen, zwischen denen der aktive Bereich angeordnet ist. Weiterhin kann die Halbleiterschichtenfolge als so genannter "Distributed Feedback Laser", kurz DFB-Laser, ausgeführt sein. Derartige DFB-Laser weisen einen in Abstrahlrichtung periodisch strukturierten aktiven Bereich auf. Der periodisch strukturierte aktive Bereich weist periodisch angeordnet Bereiche mit wechselnden Brechungsindices auf, die ein Interferenzgitter bzw. Interferenzfilter bilden können, das zu einer wellenlängenselektiven Reflexion führen kann. Die hier erwähnten Resonatorstrukturen sind dem Fachmann bekannt und werden daher nicht weiter ausgeführt.

Die Filterstruktur kann zumindest ein erstes Filterelement aufweisen, das der Halbleiterschichtenfolge in Abstrahlrichtung nachgeordnet ist. Das kann bedeuten, dass das erste Filterelement auf oder über der Strahlungsauskoppelfläche aufgebracht oder angeordnet ist.

Dass eine Schicht oder ein Element "auf" oder "über" einer anderen Schicht oder einem anderen Element oder auch "zwischen" zwei anderen Schichten oder Elementen angeordnet oder aufgebracht ist, kann dabei hier und im Folgenden bedeuten, dass die eine Schicht oder das eine Element unmittelbar im direkten mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht angeordnet sein.

Beispielsweise kann das erste Filterelement ein Halbleitermaterial mit einer Bandlücke aufweisen, die kleiner als die Energie der kohärenten ersten elektromagnetischen Strahlung ist. Als Energie einer elektromagnetischen Strahlung mit einem Wellenlängenbereich kann dabei die Energie bezeichnet werden, die einer mittleren Wellenlänge des Wellenlängenbereichs entspricht.

Weiterhin kann die Bandlücke kleiner als die Energie der inkohärenten zweiten elektromagnetischen Strahlung sein. Dadurch, dass die Bandlücke kleiner als die Energie der kohärenten ersten elektromagnetischen Strahlung und/oder der inkohärenten zweiten elektromagnetischen Strahlung ist, kann es möglich sein, dass die kohärente erste elektromagnetische Strahlung und/oder die inkohärente zweite elektromagnetische Strahlung im Halbleitermaterial angeregte Elektronenzustände durch Absorption der kohärenten ersten elektromagnetischen Strahlung bzw. der inkohärenten zweiten elektromagnetischen Strahlung erzeugen kann. Bevorzugt wird die bei Abregung der angeregten Elektronenzustände wieder freiwerdende Energie als Wärme, etwa als Gitterschwingungen, im Halbleitermaterial abgegeben.

Durch die mit der Anregung der Elektronenzustände verbundene Absorption kann die kohärente erste elektromagnetische Strahlung und/oder die inkohärente zweite elektromagnetische Strahlung abgeschwächt werden. In Abhängigkeit von der auf das Halbleitermaterial eingestrahlten Intensität und der Lebensdauer der angeregten Elektronenzustände kann in dem Halbleitermaterial bei einer Grenzintensität ein Zustand erreicht werden, in dem das Halbleitermaterial eingestrahlte elektromagnetische Strahlung nicht weiter absorbieren kann, so dass das Halbleitermaterial nunmehr transparent ist. Dieses Verhalten des Halbleitermaterials kann auch als Sättigungsverhalten bezeichnet werden.

Der transparente Zustand kann dabei insbesondere von der lokal auf das Halbleitermaterial eingestrahlten Intensität abhängen. Das kann bedeuten, dass das erste Filterelement in zumindest einem ersten Filterbereich transparent sein kann, in dem die Intensität der eingestrahlten elektromagnetischen Strahlung ausreichend ist, einen transparenten Zustand hervorzurufen, und damit größer oder gleich der Grenzintensität ist. Gleichzeitig kann das erste Filterelement in einem zweiten Filterbereich, in dem die Intensität der eingestrahlten elektromagnetischen Strahlung unterhalb der Grenzintensität liegt, noch absorbierend und daher in diesem Bereich nicht oder zumindest nicht vollständig transparent sein.

Insbesondere kann die Grenzintensität daher so durch die Wahl des Halbleitermaterials eingestellt werden, dass die zweite Intensität gerade noch kleiner als die Grenzintensität ist, so dass das erste Filterelement über dem zweiten Teilbereich der Strahlungsauskoppelfläche nicht-transparent ist. Die Grenzintensität kann dabei kleiner als die erste Intensität sein, so dass das erste Filterelement über dem ersten Teilbereich der Strahlungsauskoppelfläche transparent ist und kohärente erste elektromagnetische Strahlung durch das erste Filterelement abgestrahlt werden kann.

Dabei kann die Differenz zwischen der Bandlücke des Halbleitermaterials und der mittleren Energie der inkohärenten zweiten elektromagnetischen Strahlung zumindest der halben Breite des zweiten Wellenlängenbereichs entsprechen. Dadurch kann es möglich sein, dass zumindest 80%, bevorzugt zumindest 90% und besonders bevorzugt die gesamte, das heißt mehr als 99% der inkohärenten zweiten elektromagnetischen Strahlung vom ersten Filterelement absorbiert werden kann. Die Differenz kann dabei beispielsweise größer oder gleich 10 meV und kleiner oder gleich 15 meV sein.

Die Einstellung der intensitätsabhängigen Durchlässigkeit und die Grenzintensität können beispielsweise durch die Dicke, die Kristallqualität und die Wahl des Halbleitermaterials erfolgen. Der Anteil einer elektromagnetischen Strahlung, der durch das Halbleitermaterial im ersten Filterelement transmittiert werden kann, kann dabei reziprok exponentiell von der Dicke des Halbleitermaterials bzw. einer Schicht mit dem Halbleitermaterial abhängen. Dabei kann die Dicke beispielsweise derart gewählt sein, dass von einer elektromagnetischen Strahlung, die mit einer Intensität unterhalb der Grenzintensität auf das erste Filterelement eingestrahlt wird, der Anteil, der durch das erste Filterelement transmittiert wird, kleiner oder gleich 1/e und bevorzugt kleiner oder gleich 1/e² ist, wobei e die Eulersche Zahl ist.

Das erste Filterelement kann beispielsweise eines oder mehrere Materialien aus III-V-Halbleitermaterialsystemen wie etwa InAlGaAs, InGaAlP und InGaAlN, II-VI-Halbleitermaterialsystemen wie etwa ZnSe und ZnS oder Halbleitermaterialien wie etwa Si und Ge aufweisen. Weiterhin kann das Halbleitermaterial mit einem oder mehreren der Materialien C, Mg, Zn, Si, Te, Se, Fe, Cr und O dotiert sein. Das erste Filterelement kann beispielsweise eine Schicht mit dem Halbleitermaterial aufweisen. Weiterhin kann das erste Filterelement zwei dielektrische Schichten aufweisen, zwischen den die Schicht mit dem Halbleitermaterial angeordnet ist. Das Einbetten der Schicht mit dem Halbleitermaterial zwischen den dielektrischen Schichten kann dabei mittels Abscheiden einer Schichtenfolge erfolgen. Das Halbleitermaterial kann dabei eine epitaktisch gewachsene Schicht oder auch eine multikristalline oder amorphe Schicht bilden. Die dielektrischen Schichten können beispielsweise ein in Zusammenhang mit den oben beschriebenen Bragg-Spiegeln genanntes Oxid- oder Nitridmaterial aufweisen. Alternativ oder zusätzlich kann die Schicht mit dem Halbleitermaterial ein Matrixmaterial, vorzugsweise ein dielektrisches Oxid- oder Nitridmaterial, aufweisen, in das das Halbleitermaterial amorph eingebettet sein kann. Beispielsweise kann die Schicht mit dem Halbleitermaterial SiN als Matrixmaterial aufweisen, in das amorphes Si eingebettet ist.

Alternativ oder zusätzlich zum Halbleitermaterial kann das erste Filterelement einen Wellenlängenkonversionsstoff aufweisen, der geeignet ist, die inkohärente zweite elektromagnetische Strahlung mit dem zweiten Wellenlängenbereich in elektromagnetische Strahlung mit einem dritten Wellenlängenbereich umzuwandeln, der verschieden vom zweiten Spektrum ist. Der Wellenlängenkonversionsstoff kann dabei wie das Halbleitermaterial eine Grenzintensität und ein Sättigungsverhalten aufweisen. Die Grenzintensität des Wellenlängenkonversionsstoffs kann durch Wahl des Materials und die Dicke derart eingestellt werden, dass die inkohärente zweite elektromagnetische Strahlung das erste Filterelement noch nicht sättigen kann, während die erste Intensität der kohärenten ersten elektromagnetischen Strahlung größer als die Grenzintensität ist, so dass das erste Filterelement über dem ersten Teilbereich der Strahlungsauskoppelfläche gesättigt ist und daher transparent für zumindest einen Teil der kohärenten ersten elektromagnetischen Strahlung. Zusätzlich oder alternativ kann auch das vorab beschrieben Halbleitermaterial bei der Abregung der angeregten Elektronenzustände eine elektromagnetische Strahlung mit einem dritten Spektrum abstrahlen und damit zumindest teilweise wie ein Wellenlängenkonversionsstoff wirken.

Dabei kann es vorteilhaft sein, wenn der dritte Wellenlängenbereich beispielsweise im infraroten Wellenlängenbereich liegt und somit für das menschliche Auge nicht mehr wahrnehmbar ist. Alternativ oder zusätzlich kann die Filterstruktur ein drittes Filterelement aufweisen, das dem ersten Filterelement ein drittes Filterelement nachgeordnet und für die elektromagnetische Strahlung mit dem dritten Wellenlängenbereich nicht transparent ist. Das dritte Filterelement kann dabei insbesondere transparent für die kohärente erste elektromagnetische Strahlung sein. Beispielsweise kann das dritte Filterelement einen absorptiven Farbfilter umfassen.

Das dritte Filterelement kann beispielsweise als separates Bauelement, etwa als Gehäusefenster oder als Teil davon, dem ersten Filterelement in Abstrahlrichtung nachgeordnet sein. Dadurch kann beispielsweise die thermische Last an der Strahlungsauskoppelfläche gesenkt werden, wodurch die Lebensdauer der Halbleiterschichtenfolge erhöht werden kann.

Der Wellenlängenkonversionsstoff kann einen oder mehrere der folgenden Materialien aufweisen: Granate der Seltenen Erden und der Erdalkalimetalle, beispielsweise YAG:Ce³⁺, Nitride, Nitridosilikate, Sione, Sialone, Aluminate, Oxide, Halophosphate, Orthosilikate, Sulfide, Vanadate und Chlorosilikate. Weiterhin kann der Wellenlängenkonversionsstoff zusätzlich oder alternativ ein organisches Material umfassen, das aus einer Gruppe ausgewählt sein kann, die Perylene, Benzopyrene, Coumarine, Rhodamine und Azo-Farbstoffe umfasst. Die Wellenlängenkonversionsschicht kann geeignete Mischungen und/oder Kombinationen der genannten Wellenlängenkonversionsstoffe aufweisen.

Weiterhin kann das erste Filterelement ein transparentes Matrixmaterial umfassen, das den oder die Wellenlängenkonversionsstoffe umgibt oder enthält oder das an den oder die Wellenlängenkonversionsstoffe chemisch gebunden ist. Das transparente Matrixmaterial kann beispielsweise Siloxane, Epoxide, Acrylate, Methylmethacrylate, Imide, Carbonate, Olefine, Styrole, Urethane oder Derivate davon in Form von Monomeren, Oligomeren oder Polymeren und weiterhin auch Mischungen, Copolymere oder Verbindungen damit aufweisen. Beispielsweise kann das Matrixmaterial ein Epoxidharz, Polymethylmethacrylat (PMMA), Polystyrol, Polycarbonat, Polyacrylat, Polyurethan oder ein Silikonharz wie etwa Polysiloxan oder Mischungen daraus umfassen oder sein.

Aufgrund der ersten Intensität der kohärenten ersten elektromagnetischen Strahlung kann in einem ersten Filterbereich des ersten Filterelements eine erste Temperatur erzeugt werden, während in einem zweiten Filterbereich des ersten Filterelements eine zweite Temperatur aufgrund der zweiten Intensität der inkohärenten zweiten elektromagnetischen Strahlung erzeugt werden kann. Da die zweite Intensität niedriger als die erste Intensität sein kann, kann auch die zweite Temperatur niedriger als die erste Temperatur sein. Das kann bedeuten, dass das erste Filterelement im ersten Filterbereich, der auf oder über dem ersten Teilbereich der Strahlungsauskoppelfläche angeordnet sein kann, eine höhere Temperatur aufweisen kann als im zweiten Filterbereich, der auf oder über dem zweiten Teilbereich der Strahlungsauskoppelfläche angeordnet sein kann.

Das erste Filterelement kann weiterhin eine temperaturabhängige Durchlässigkeit für elektromagnetische Strahlung aufweisen. Dabei kann das erste Filterelement ein Grenztemperatur aufweisen, unterhalb derer das erste Filterelement nicht transparent ist. Insbesondere kann die Grenztemperatur größer als die zweite Temperatur und kleiner als die erste Temperatur sein. Das kann bedeuten, dass das erste Filterelement nur im ersten Filterbereich transparent ist, so dass die inkohärente zweite elektromagnetische Strahlung, die vom zweiten Teilbereich der Strahlungsauskoppelfläche abgestrahlt wird, nicht durch das erste Filterelement abgestrahlt werden kann.

Das erste Filterelement kann beispielsweise ein Material aufweisen, bei dem sich in Abhängigkeit von der Temperatur die atomare oder molekulare Nahordnung ändern kann. Beispielsweise kann das erste Filterelement als Schicht oder Schichtenstapel ausgeführt sein, das Oberflächenplasmonenmoden aufweisen kann, die unterhalb der Grenztemperatur an die kohärente erste elektromagnetische Strahlung und an die inkohärente zweite elektromagnetische Strahlung koppeln können. Als Plasmonen können dabei periodisch oszillierende Dichteschwankungen freier Ladungsträger, etwa Elektronen, im ersten Filterelement bzw. einer Schicht des ersten Filterelements bezeichnet werden. Insbesondere bezeichnen Oberflächenplasmonen hierbei longitudinale Ladungsträgerdichteschwingungen, die parallel zur Erstreckungsebene einer Oberfläche einer Schicht des ersten Filterelements an dieser Oberfläche auftreten. Die Oberflächenplasmonenmoden können dabei abhängig von der atomaren oder molekularen Nahordnung zumindest einer Schicht im ersten Filterelement sein. Oberflächenplasmonen können dabei insbesondere an der der Halbleiterschichtenfolge zugewandten Oberfläche der Schicht des ersten Filterelements erzeugt werden. Durch die Kopplung von elektromagnetischer Strahlung an Oberflächenplasmonen im ersten Filterelement, was auch als Oberflächenplasmonenresonanz bezeichnet werden kann, kann Energie der elektromagnetischen Strahlung auf das erste Filterelement übertragen werden, so dass zumindest ein Teil der Energie der elektromagnetischen Strahlung absorbiert werden kann. Das erste Filterelement kann dadurch in dem Bereich, in dem elektromagnetische Strahlung auf das erste Filterelement eingestrahlt wird, erwärmt werden.

Solange die Temperatur in einem Filterbereich des ersten Filterelements unterhalb der Grenztemperatur bleibt, können Oberflächenplasmonenmoden in diesem Filterbereich im ersten Filterelement vorhanden sein, an die eine elektromagnetische Strahlung koppeln kann. Durch die Erwärmung des ersten Filterelements in zumindest einem Filterbereich auf einer Temperatur größer oder gleich der Grenztemperatur kann die atomare oder molekulare Nahordnung zumindest einer Schicht des ersten Filterelements derart verändert sein, dass keine Oberflächenplasmonenmoden mehr vorhanden sind, an die die elektromagnetische Strahlung koppeln kann, so dass das erste Filterelement in dem Filterbereich transparent ist. Die Änderung der atomaren oder molekularen Nahordnung kann dabei beispielsweise durch eine temperaturabhängige Dichteänderung und/oder eine Phasenänderung wie etwa Mikroblasenbildung in zumindest einer Schicht des ersten Filterelements erreichbar sein.

Die Grenztemperatur kann mittels des Materials zumindest einer Schicht des ersten Filterelements einstellbar sein. Beispielsweise kann die zumindest eine Schicht ein Material aus einer Gruppe aufweisen, die gebildet wird durch Antimon, Silber, Platin, Palladium und Zink. Insbesondere kann das erste Filterelement einen Schichtenstapel aufweisen, der zumindest eines der genannten Materialien aufweisen kann. Für kohärente erste elektromagnetische Strahlung und inkohärente zweite elektromagnetische Strahlung aus einem blauen Wellenlängenbereich kann das erste Filterelement bevorzugt eine Schicht mit Antimon mit einem oder mehreren der Materialien N, Te, Ge, Ag und In aufweisen, beispielsweise Antimonnitrid (SbNₓ), SbTe, GeSbTe und/oder AgInSbTe. Weiterhin kann das erste Filterelement einen Schichtenstapel mit den genannten Materialien in einer Schicht aufweisen, die zwischen zwei Siliziumnitridschichten angeordnet ist. Alternativ oder zusätzlich kann das erste Filterelement auch einen Schichtenstapel mit einer ZnS-SiO₂-Schicht zwischen zwei PtOₓ-Schichten aufweisen. Für einen roten ersten und zweiten Wellenlängenbereich kann das erste Filterelement beispielsweise eine Schicht mit AgOₓ, PtOₓ und/oder PdOₓ aufweisen. Derartige Schichten oder Schichtenstapel können auch als "super-resolution near-field structure" (Super-RENS) bezeichnet werden.

Weiterhin kann die Filterstruktur ein viertes Filterelement aufweisen, das auf einer Fläche der Halbleiterschichtenfolge angeordnet ist, die etwa eine Oberfläche der Halbleiterschichtenfolge sein kann. Die Oberfläche mit dem vierten Filterelement kann dabei von der Strahlungsauskoppelfläche und der der Strahlungsauskoppelfläche gegenüberliegenden Oberfläche verschieden sein. Insbesondere kann das vierte Filterelement auf einer Fläche angeordnet sein, die eine Erstreckungsrichtung aufweist, die parallel zur Abstrahlrichtung der kohärenten ersten elektromagnetischen Strahlung ist. Eine derartige Fläche kann beispielsweise eine Seitenfläche der Halbleiterschichtenfolge sein, die sich von der Strahlungsauskoppelfläche zur der Strahlungsauskoppelfläche gegenüberliegenden Oberfläche erstreckt.

Darüber hinaus kann die Fläche auch eine Grenzfläche einer Schicht der Halbleiterschichtenfolge sein, wobei die Halbleiterschichtenfolge wie oben beschrieben eine Mehrzahl von Schichten aufweisen kann. Insbesondere kann die Fläche dabei eine Grenzfläche zwischen zwei Schichten der Halbleiterschichtenfolge sein.

Das vierte Filterelement kann dabei eine Schicht mit einem nicht-transparenten Material aufweisen. Das nicht-transparente Material kann insbesondere auch ein für die inkohärente zweite elektromagnetische Strahlung absorbierendes Material sein. Die Schicht mit dem nicht-transparenten Material kann dabei beispielsweise auf einer dem aktiven Bereich abgewandten Oberfläche des Substrats oder auf einer dem aktiven Bereich zugewandten Oberfläche des Substrats aufgebracht sein. Weiterhin kann die Schicht mit dem nicht-transparent Material auf einer dem aktiven Bereich abgewandten Oberfläche einer Wellenleiterschicht, beispielsweise als nicht-transparente Mantelschicht oder als Teil davon, zwischen dem aktiven Bereich und einem elektrischen Kontakt wie etwa einer Elektrode oder auch zwischen dem aktiven Bereich und dem Substrat aufgebracht sein. Derartige Anordnungen des vierten Filterelements können eine Ausbreitung der inkohärenten zweiten elektromagnetischen Strahlung innerhalb der Halbleiterschichtenfolge insbesondere in Richtung einer Elektrode und/oder in Richtung des Substrats verhindern oder zumindest verringern, was insbesondere vorteilhaft bei einer Halbleiterschichtenfolge mit einem transparenten Substrat wie etwa GaN sein kann. Dadurch kann eine Verringerung der in Abstrahlrichtung abgestrahlten inkohärenten zweiten elektromagnetischen Strahlung über den zweiten Teilbereich der Strahlungsauskoppelfläche verringert werden kann.

Das nicht-transparente, vorzugsweise absorbierende Material kann dabei bevorzugt elektrisch leitend sein und eines der Materialien Silizium, Gallium, Germanium, Aluminium, Chrom oder Titan oder eine Kombination aufweisen.

Alternativ oder zusätzlich kann das vierte Filterelement eine zur elektrischen Kontaktierung der Halbleiterschichtenfolge vorgesehenen Elektrode umfassen. Die Elektrode kann dabei ein schlecht reflektierendes und/oder schlecht transmittierendes und vorzugsweise absorbierendes Material umfassen wie etwa Chrom und/oder Titan.

Weiterhin kann das vierte Filterelement eine Mehrzahl von absorbierenden Schichten aufweisen, die auf einer Mehrzahl von Oberflächen der Halbleiterschichtenfolge, die verschieden von der Strahlungsauskoppelfläche oder zumindest vom ersten Teilbereich der Strahlungsauskoppelfläche sind.

Weiterhin kann das vierte Filterelement eine Oberflächenstruktur aufweisen oder umfassen. Die Oberflächenstruktur kann beispielsweise eine Aufrauung und/oder zumindest eine Vertiefung in zumindest einer Oberfläche der Halbleiterschichtenfolge, die verschieden von der Strahlungsauskoppelfläche ist, sein. Insbesondere kann die Halbleiterschichtenfolge eine Aufwachsrichtung aufweisen, in der die Schichten der Halbleiterschichtenfolge übereinander aufgewachsen sind. Damit kann die Halbleiterschichtenfolge auch zumindest eine Oberfläche aufweisen, die senkrecht zur Aufwachsrichtung angeordnet ist. Die Oberfläche kann beispielsweise eine dem aktiven Bereich zugewandte oder eine von diesem abgewandte Oberfläche des Substrats oder einer elektrischen Kontaktschicht, etwa einer Elektrode, sein.

Beispielsweise können eine oder mehrere Schichten der Halbleiterschichtenfolge auf einer dem Substrat abgewandten Seite des aktiven Bereichs stegförmig in einer oben beschriebenen Ridge- oder Trapezstruktur ausgebildet sein. Die Oberfläche mit der Oberflächenstruktur kann dann bevorzugt eine zu der oder den stegförmig ausgeführten Schichten lateral versetzte, benachbarte und/oder angrenzende Oberfläche sein. In dieser Oberfläche kann die Oberflächenstruktur lateral versetzt zum aktiven Bereich angeordnet sein.

Die Oberflächenstruktur kann weiterhin eine Tiefe aufweisen, die derart ist, dass die als Aufrauung oder Vertiefung ausgebildete Oberflächenstruktur in die Halbleiterschichtenfolge hineinreicht. Das kann bedeuten, dass sich die Oberflächenstruktur in zumindest eine Schicht oder in mehrere benachbarte Schichten der Halbleiterschichtenfolge in die Halbleiterschichtenfolge hinein erstreckt. Besonders bevorzugt kann die Oberflächenstruktur außerhalb des aktiven Bereichs in die Halbleiterschichtenfolge hineinragen.

Beispielsweise kann die Oberflächenstruktur eine Aufrauung oder zumindest eine Vertiefung aufweisen, die seitlich versetzt zum aktiven Bereich bis in eine Wellenleiterschicht der Halbleiterschichtenfolge hineinragt. Die Oberflächenstruktur kann zumindest hundert Nanometer, bevorzugt zumindest einen Mikrometer und besonders bevorzugt bis zu Mikrometer seitlich vom aktiven Bereich und/oder von einer Ridge- oder Trapezstruktur versetzt angeordnet sein.

Beispielsweise kann die Oberflächenstruktur eine Aufrauung mit einer mittleren Periode von etwa einem Zehntel des ersten und/oder zweiten Wellenlängenbereichs aufweisen und eine Tiefe in die Halbleiterschichtenfolge hinein derart aufweisen, dass die den aktiven Bereich beinhaltende Schicht der Halbleiterschichtenfolge vorzugsweise nicht von der Aufrauung durchstoßen wird. Die Aufrauung kann beispielsweise durch trocken- oder nasschemisches Ätzen herstellbar sein.

Weiterhin kann die Oberflächenstruktur zumindest einen Graben oder eine regelmäßige Anordnung von Vertiefungen aufweisen. Der Graben oder die regelmäßige Anordnung von Vertiefungen kann eine Erstreckungsrichtung parallel zur Erstreckungsrichtung der Schichten der Halbleiterschichtenfolge aufweisen und mit der Abstrahlrichtung der kohärenten ersten elektromagnetischen Strahlung einen Winkel einschließen, der größer oder gleich 0° und kleiner oder gleich 90° sein kann.

Ein Winkel von 0° kann insbesondere bedeuten, dass der zumindest eine Graben oder die regelmäßige Anordnung von Vertiefungen parallel zur Abstrahlrichtung und damit parallel zu einer Erstreckungsrichtung des aktiven Bereichs ausgerichtet ist. Alternativ oder zusätzlich kann das vierte Filterelement zumindest einen Graben aufweisen, dessen Erstreckungsrichtung mit der Abstrahlrichtung einen Winkel von größer als 0° und kleiner als 90°, bevorzugt größer oder gleich 30° und kleiner oder gleich 60° und besonders bevorzugt etwa 45° einschließt. Das kann insbesondere bedeuten, dass sich der Graben in Richtung der Abstrahlrichtung dem aktiven Bereich annähert.

Der Graben oder die regelmäßige Anordnung von Vertiefungen kann dabei eine Tiefe derart aufweisen, dass sich der Graben oder die Vertiefungen in die Halbleiterschichtenfolge bis zu einem Abstand von kleiner oder gleich 200 nm über einer Wellenleiterschicht der Halbleiterschichtenfolge erstrecken. Weiterhin kann sich eine derartige Oberflächenstruktur auch bis in die Wellenleiterschicht hinein oder auch von einer dem Substrat gegenüberliegenden Oberfläche der Halbleiterschichtenfolge bis in das Substrat hinein erstrecken.

Der Graben oder die Vertiefungen können dabei einen Querschnitt mit zur Aufwachsrichtung der Halbleiterschichtenfolge parallelen Seitenflächen oder bis zu einem Winkel von 45° zur Aufwachsrichtung angeschrägten Seitenflächen aufweisen. Das kann bedeuten, dass der Graben oder die Vertiefungen einen U-förmigen oder V-förmigen Querschnitt haben können. Durch angeschrägte Seitenflanken kann inkohärente zweite elektromagnetische Strahlung, die sich innerhalb der Halbleiterschichtenfolge ausbreitet abgelenkt und beispielsweise zu einer oben beschriebenen Schicht mit einem absorbierenden Material gelenkt werden. Der Graben oder die Vertiefungen können zusätzlich auch zumindest teilweise mit einem der oben beschriebenen absorbierenden Materialien oder einem der Super-RENS-Materialien beschichtet oder gefüllt sein.

Besonders bevorzugt können die hier beschriebenen Oberflächenstrukturen paarweise symmetrisch zu einer Ridge- oder Trapezstruktur auf einer zu einer solchen Struktur benachbarten Oberfläche angeordnet sein.

Weiterhin können eine Mehrzahl von Gräben oder regelmäßigen Anordnungen von Vertiefungen parallel zueinander verlaufend nebeneinander angeordnet werden. Dabei können die Mehrzahl von Gräben oder regelmäßigen Anordnungen von Vertiefungen einem Abstand von kleiner oder gleich einer mittleren Wellenlänge des ersten und/oder zweiten Wellenlängenbereichs und besonders bevorzugt einen Abstand von etwa einem Viertel der mittleren Wellenlänge aufweisen. Durch eine derartige Abfolge von Gräben oder Vertiefungen kann die Oberflächenstruktur ähnlich oder gleich einem ein- oder zweidimensionalen photonischen Kristall wirken.

Durch eine stegförmige Ausbildung einer Ridge- oder Trapezstruktur in zumindest einer oder mehreren Schichten der Halbleiterschichtenfolge kann ein Brechungsindexsprung von typischerweise 0,001 bis 0,01 ergeben kann, so dass die stegförmige Struktur eine Wellenleitung ermöglichen kann. Dadurch und durch Wellenleiterschichten in der Halbleiterschichtenfolge kann die inkohärente zweite elektromagnetische Strahlung innerhalb der

Halbleiterschichtenfolge in Richtung der Strahlungsauskoppelfläche geleitet werden. Durch das hier beschriebene vierte Filterelement kann eine derartige Ausbreitung der inkohärenten zweiten elektromagnetischen Strahlung innerhalb der Halbleiterschichtenfolge in einer Richtung parallel zur Erstreckungsrichtung der Schichten der Halbleiterschichtenfolge wirksam verringert oder verhindert werden. Dadurch kann es möglich sein, dass die Abstrahlung der inkohärenten zweiten elektromagnetischen Strahlung vom zweiten Teilbereich der Strahlungsauskoppelfläche reduziert werden kann.

Die Filterstruktur kann eines der hier beschriebenen ersten, zweiten, dritten und vierten Filterelemente alleine aufweisen. Weiterhin kann die Filterstruktur auch mehrere der hier beschriebenen ersten, zweiten, dritten und vierten Filterelemente in Kombination aufweisen. Gerade dadurch kann die gewünschte Filtereigenschaft der Filterstruktur auf die Abstrahlcharakteristik sowie auf die verwendeten Materialien und Ausführungen der Halbleiterschichtenfolge angepasst werden. Beispielsweise kann die Filterstruktur auch eines der oben beschriebenen ersten Filterelemente direkt auf der Halbleiterschichtenfolge angeordnet aufweisen und ein weiteres der oben beschriebenen ersten Filterelemente als Teil eines der Halbleiterschichtenfolge in Abstrahlrichtung nachgeordneten Gehäusefensters. Weiterhin können etwa auch erste und/oder zweite und/oder dritte Filterelemente beispielsweise in Kombination mit vierten Filterelementen die Filterstruktur bilden.

Weitere Vorteile und vorteilhafte Ausführungsformen und Weiterbildungen der Erfindung sowie Beispiele ergeben sich aus den im
Folgenden in Verbindung mit den Figuren 1A bis 17 beschriebenen Ausführungsformen.

Es zeigen:
Figuren 1A bis 1F schematische Darstellungen einer
Laserlichtquelle gemäß einem Ausführungsbeispiel, Figur 2 eine Abstrahlcharakteristik einer Laserlichtquelle,
Figuren 3A bis 6 schematische Darstellungen von Laserlichtquellen gemäß weiterer Ausführungsbeispiele sowie weiterer Beispiele,
Figuren 7A bis 9B wellenlängen- und winkelabhängige Durchlässigkeiten von ersten und zweiten Filterelementen gemäß weiterer Beispiele und
Figuren 10 bis 17 schematische Darstellungen von Laserlichtquellen gemäß weiterer Beispiele und weiterer Ausführungsbeispiele.

In den Ausführungsbeispielen, Beispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

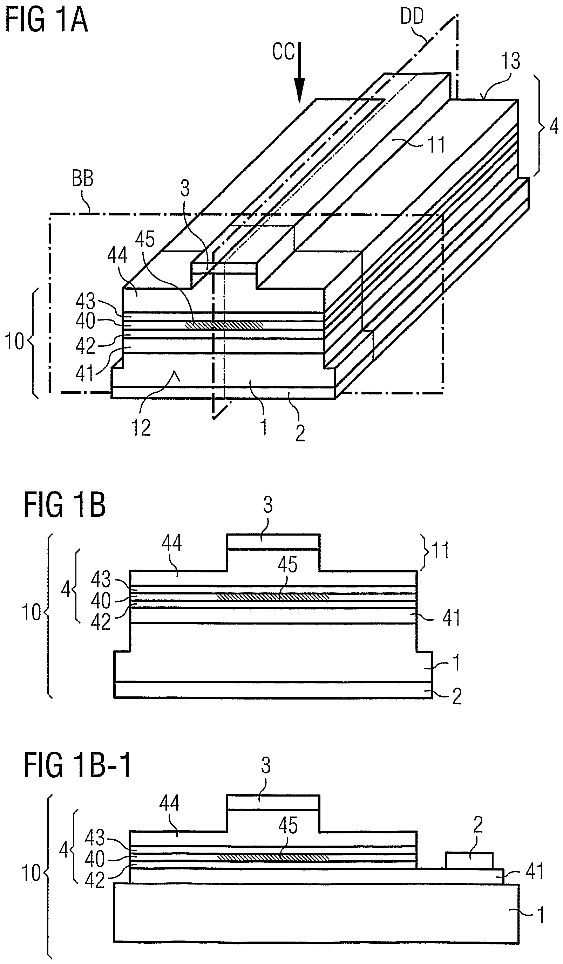

In den Figuren 1A bis 1F ist ein Ausführungsbeispiel für eine Laserlichtquelle gezeigt. Die nachfolgende Beschreibung zu diesem Ausführungsbeispiel bezieht sich, soweit nicht ausdrücklich anders gekennzeichnet, gleichermaßen auf alle Figuren 1A bis 1F.

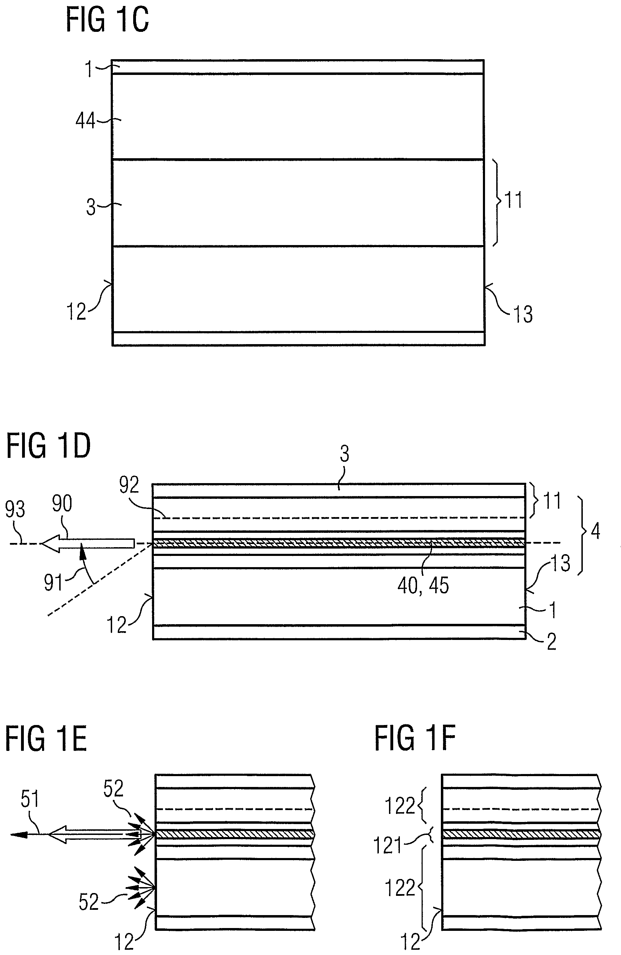

Dabei zeigt Figur 1A eine schematische räumliche Darstellung der Laserlichtquelle mit einer Halbleiterschichtenfolge 10. Die Figur 1B zeigt eine Schnittansicht der Laserlichtquelle entlang der in Figur 1A mit BB gekennzeichneten Schnittebene und Figur 1C eine Draufsicht auf die Laserlichtquelle von oben entlang der in Figur 1A mit CC gekennzeichneten Richtung. In den Figuren 1D bis 1F sind Schnittansichten und Ausschnitte von Schnittansichten entlang der in Figur 1A gekennzeichneten Schnittebene DD gezeigt.

Um die der hier beschriebenen Laserlichtquelle zugrunde liegenden Überlegungen darzustellen, ist in den Figuren 1A bis 1F keine Filterstruktur 5 gezeigt. Die in diesen Figuren gezeigte Laserlichtquelle kann jedoch jegliche im allgemeinen Teil und in den weiteren Ausführungsbeispielen gezeigte Filterstrukturen 5 aufweisen.

Die Laserlichtquelle weist eine Halbleiterschichtenfolge 10 mit einem Substrat 1 auf, auf dem eine Mehrzahl von funktionellen, epitaktisch aufgewachsenen Schichten 4 aufgebracht ist.

Die Halbleiterschichtenfolge 10 wird dabei im gezeigten Ausführungsbeispiel gebildet durch ein GaN-Substrat 1, auf dem eine Silizium-dotierte AlGaN-Mantelschicht 41 und darüber eine Silizium-dotierte GaN-Wellenleiterschicht 42 angeordnet ist. Darüber weist die Halbleiterschichtenfolge 10 eine aktive Schicht mit einer Mehrfach-Quantentopfstruktur (MQW-Struktur) mit 1 bis 5 GaInN-Quantenfilmen und GaN-Barriereschichten auf. Auf der aktiven Schicht sind eine Magnesium-dotierte GaN-Wellenleiterschicht 43 und eine Magnesium-dotierte AlGaN-Mantelschicht 44 aufgebracht. Weiterhin können auf der Mantelschicht 44 noch eine oder mehrere Kontaktschichten beispielsweise aus Magnesiumdotiertem GaN aufgebracht sein, während zwischen dem Substrat 1 und der Mantelschicht 41 ebenfalls eine oder mehrere Zwischenschichten angeordnet sein können (nicht gezeigt). Die Halbleiterschichtenfolge 10 ist aufgrund des beschriebenen Materialsystems geeignet, elektromagnetische Strahlung in einem ultravioletten bis grünen und bevorzugt in einem blauen Wellenlängenbereich zu erzeugen.

Alternativ zu den hier beschriebenen Nitrid-basierten Halbleitermaterialien kann die Halbleiterschichtenfolge 10 beispielsweise auch Phosphid- und Arsenid-basierte Halbleitermaterialien aufweisen, so etwa beispielsweise ein GaAs-Substrat 1 und darüber eine 100 nm dicke Zwischenschicht 41 aus AlGaAs mit einem Al-Anteil von etwa 40% an den Gruppe-III-Materialien und/oder aus InGaP mit einem In-Anteil von etwa 50% an den Gruppe-III-Materialien, darüber eine 2 µm dicke InAlP-Wellenleiterschicht 42, darüber eine 100 nm dicke InGaAlP/InGaP-Quantenfilm/Barriereschichten-MQW-Struktur mit einem In-Anteil von etwa 50% und einem Al-Anteil von etwa 25%, darüber eine 2 µm dicke InAlP-Wellenleiterschicht 43 sowie darüber eine 100 nm dicke InGaP-Zwischenschicht 44 und weiterhin eine 300 nm dicke GaAs-Kontaktschicht (nicht gezeigt). Eine derartige Halbleiterschichtenfolge 10 kann geeignet sein, grün bis infrarote elektromagnetische Strahlung zu erzeugen und besonders bevorzugt elektromagnetische Strahlung in einem roten Wellenlängenbereich.

Das Substrat 1 kann dabei ein Aufwachssubstrat sein, auf der die funktionalen Schichten epitaktisch aufgewachsen werden. Alternativ dazu kann die Halbleiterschichtenfolge in Dünnfilm-Technologie herstellbar sein. Das bedeutet, dass die funktionalen Schichten auf einem Aufwachssubstrat aufgewachsen und anschließen auf ein Trägersubstrat, das dann das Substrat 1 der Halbleiterschichtenfolge 10 bildet, übertragen wird. Je nach Aufwachstechnik können dabei die n-leitenden Schichten oder die p-leitenden Schichten der Halbleiterschichtenfolge 10 dem Substrat 1 zugewandt sein. In Figur 1D ist weiterhin durch die gestrichelte Linie 93 die Erstreckungsebene der funktionalen Schichten 4 der Halbleiterschichtenfolge 10 angedeutet, die senkrecht zur Aufwachsrichtung der funktionalen Schichten 4 ist.

Die elektrische Kontaktierung der Halbleiterschichtenfolge 10 erfolgt über eine Elektrode 2 auf der den funktionellen Schichten 4 abgewandten Oberfläche des Substrats 1 und eine Elektrode 3 auf der dem Substrat 1 gegenüberliegenden Oberfläche der funktionellen Schichten 4. Die Elektroden 2 und 3 können dabei jeweils eine oder mehrere Schichten mit Ag, Au, Sn, Ti, Pt, Pd, Cr, Ni und/oder Ge aufweisen.

Alternativ zur elektrischen Kontaktierung gemäß der Figuren 1A, 1B und 1C bis 1F durch das Substrat 1 hindurch kann der elektrische Kontakt 2 auch auf derselben Seite der Substrats 1 wie die funktionellen Schichten 4 angeordnet sein wie in Figur 1B-1 angedeutet ist. Diese Kontaktierungsart ist vor allem geeignet, die funktionalen Schichten 4 von der Substratseite elektrisch zu kontaktieren, wenn diese auf einem elektrisch nicht leitfähigen Substrat 1 angeordnet sind. Alle im Folgenden beschriebenen Ausführungsbeispiele gelten auch gleichermaßen für eine Laserlichtquelle mit der in der Figur 1B-1 gezeigten Kontaktierungsausführung.

Weiterhin weist die Halbleiterschichtenfolge 10 eine Strahlungsauskoppelfläche 12 und eine dazu gegenüberliegenden als Rückseite ausgebildete Oberfläche 13 auf, die jeweils eine reflektierende Beschichtung aufweisen (nicht gezeigt). Dadurch bilden die Strahlungsauskoppelfläche 12 und die Rückseite 13 einen optischen Resonator. Die jeweilige reflektierende Beschichtung kann beispielsweise eine Bragg-Spiegel-Schichtenfolge und/oder reflektierende Metallschichten umfassen.

Auf oder über den Oberflächen der Halbleiterschichtenfolge, die verschieden von der Strahlungsauskoppelfläche sind, können weiterhin Passivierungsschichten zum Schutz der Halbleiterschichtenfolge aufgebracht sein (nicht gezeigt).

Die Mantelschicht 44 ist im gezeigten Ausführungsbeispiel teilweise stegförmig aufgebracht und bildet eine so genannte Ridge-Struktur oder Steg-Struktur 11 wie im allgemeinen Teil beschrieben. Alternativ oder zusätzlich zur gezeigten Ridge-Struktur 11 kann die Halbleiterschichtenfolge 10 auch eine Trapez-Struktur mit einem sich verbreiternden Steg 11 aufweisen. In Figur 1D ist die Kante der Ridge-Struktur 11 durch die gestrichelte Linie 92 angedeutet.

Durch die Ridge-Struktur 11 kann in der aktiven Schicht 40 die Ausbildung von kohärenter erster elektromagnetischer Strahlung 51 in einer transversalen Grundmode ermöglicht werden, wohingegen unerwünschte weitere Lasermoden unterdrückt werden können. Dadurch weist die aktive Schicht 40 einen aktiven Bereich 45 auf, der unter anderem durch die Breite der Ridge-Struktur 11 vorgegeben ist und im gezeigten Ausführungsbeispiel durch die schraffierte Fläche in der aktiven Schicht 40 angedeutet ist. Der aktive Bereich 45 erstreckt sich dabei über die gesamte Länge der aktiven Schicht 40 in dem durch die Strahlungsauskoppelfläche 12 und die Rückseite 13 gebildeten Resonator. Im aktiven Bereich 45 kann die Halbleiterschichtenfolge 10 im Betrieb durch stimulierte Emission eine kohärente erste elektromagnetische Strahlung 51 erzeugen, die über einen ersten Teilbereich 121 der Strahlungsauskoppelfläche 12 abgestrahlt werden kann. Durch die Resonatorstruktur, die Wellenleiterschichten 42, 43 und die der stimulierten Emission zugrunde liegenden bekannten Mechanismen wird die kohärente erste elektromagnetische Strahlung 51 entlang der Abstrahlrichtung 90 als Strahlenbündel oder Strahlenkeule abgestrahlt.

Weiterhin wird im Betrieb der Halbleiterschichtenfolge 10 neben der kohärenten ersten elektromagnetischen Strahlung 51 auch inkohärente zweite elektromagnetische Strahlung 52 erzeugt. Diese kann beispielsweise durch spontane Emission im aktiven Bereich 45, aber beispielsweise auch in der aktiven Schicht 40 außerhalb des aktiven Bereichs 45 in Randbereichen erzeugt werden, in denen im Betrieb Leckströme vorhanden sind. Weiterhin kann spontane Emission auch durch optisches Pumpen aus dem aktiven Bereich angeregt werden oder durch Streuung von elektromagnetischer Strahlung insbesondere an rauen Schichtenkanten. Wie im allgemeinen Teil beschrieben, wird die inkohärente zweite elektromagnetische Strahlung 52 isotrop erzeugt. Durch die Wellenleiterschichten 42, 43 kann die inkohärente zweite elektromagnetische Strahlung ebenfalls zum ersten Teilbereich 121 der Strahlungsauskoppelfläche 12 geführt werden und vom ersten Teilbereich 121 abgestrahlt werden. Daneben kann die inkohärente zweite elektromagnetische Strahlung aber zu weiteren Teilbereichen der Strahlungsauskoppelfläche 12 beispielsweise durch Streuung in der Halbleiterschichtenfolge 10 gelenkt werden und von diesen abgestrahlt werden. Damit kann über die Strahlungsauskoppelfläche 12 außerhalb des ersten Teilbereichs 121 die inkohärente zweite elektromagnetische Strahlung 52 über einen zweiten Teilbereich 122 abgestrahlt werden, der die Bereiche der Strahlungsauskoppelfläche 12 umfasst, die nicht an den aktiven Bereich 45 der Halbleiterschichtenfolge 10 grenzen. Dies ist in den Figuren 1E und 1F angedeutet, wobei in Figur 1E exemplarisch die Abstrahlung der inkohärenten zweiten elektromagnetischen Strahlung 52 von einer Oberfläche des transparenten Substrats 1 gezeigt ist, die einen Teil der Strahlungsauskoppelfläche 12 und damit es zweiten Teilbereichs 122 bildet. Eine Abstrahlung der inkohärenten zweiten elektromagnetischen Strahlung 52 über eine Oberfläche des Substrats 1 kann durch den Brechungsindexverlauf in der Halbleiterschichtenfolge 10 und die Transparenz des Substrats 1 begünstigt werden.

Die inkohärente zweite elektromagnetische Strahlung 52 kann dabei in einem weiten Winkelbereich abgestrahlt werden, wie in Figur 1E angedeutet ist. Hier und im Folgenden ist der Abstrahlwinkel für elektromagnetische Strahlung von der Strahlungsauskoppelfläche 12 als Winkel 91 zur Abstrahlrichtung 90 definiert, wie in Figur 1D angedeutet ist.

Die kohärente erste elektromagnetische Strahlung 51 weist dabei eine erste Intensität auf, die je nach Bestromung der Halbleiterschichtenfolge 10 etwa doppelt so groß bis mehr als 100 mal größer als eine zweite Intensität der inkohärenten zweiten elektromagnetischen Strahlung 52 ist.

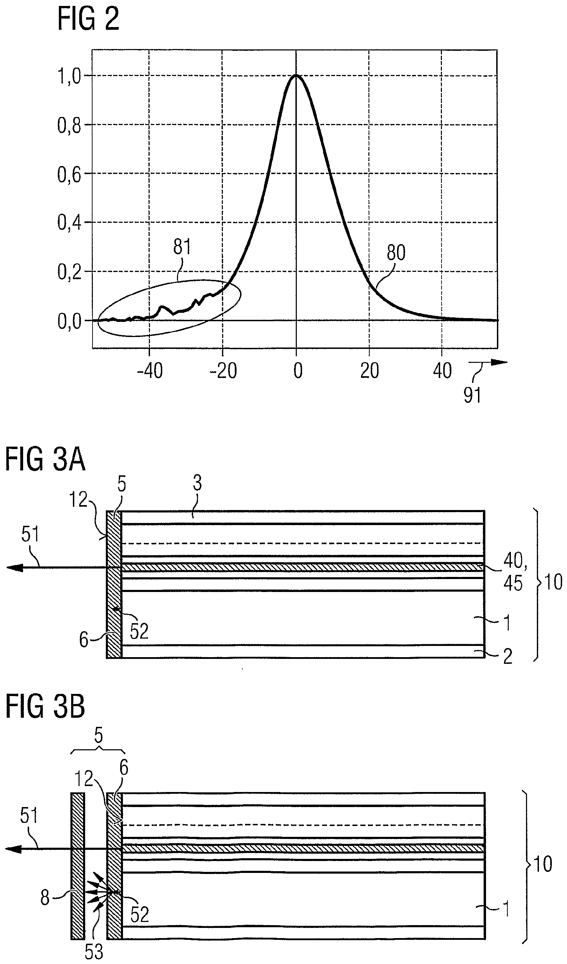

In Figur 2 ist die Abstrahlcharakteristik 80 für die Laserlichtquelle aus den Figuren 1A bis 1F ohne die im allgemeinen Teil und in den weiteren Ausführungsbeispielen beschriebene Filterstruktur 5 gezeigt. Dabei ist auf der horizontalen Abszisse der Abstrahlwinkel 91 gemäß der Figur 1D in der in Figur 1A gezeigten Schnittebene DD aufgetragen. Die vertikale Ordinate zeigt beliebige Einheiten für die Intensität der von der Laserlichtquelle abgestrahlten elektromagnetischen Strahlung. Der Peak um 0° entspricht dabei im Wesentlichen einem Gaußschen oder zumindest Gaußähnlichen Strahlprofil der kohärenten ersten elektromagnetischen Strahlung 51. Für Winkel 91 kleiner oder gleich etwa -20° ist in dem mit 81 bezeichneten Bereich zusätzlich inkohärente zweite elektromagnetische Strahlung 52 messbar, die das Strahlprofil der kohärenten ersten elektromagnetischen Strahlung 51 signifikant verschlechtert. Die Abstrahlcharakteristik 80 entspricht dabei der typischen Abstrahlcharakteristik bekannter Laserbauelemente.

Die unerwünschte Auskopplung von inkohärenter zweiter elektromagnetischer Strahlung 52 führt dazu, dass im vertikalen wie auch im horizontalen Fernfeld der Laserlichtquelle Nebenpeaks entstehen, die sich in einer signifikanten Verschlechterung der Strahlqualität niederschlagen und in beispielsweise Projektions-, Datenspeicher oder Druckanwendungen empfindlich stören können.

Durch die im allgemeinen Teil und in den folgenden Ausführungsbeispielen beschriebenen Filterstrukturen 5 kann die Abstrahlcharakteristik der hier beschriebenen Laserlichtquelle wesentlich und signifikant verbessert werden. Die Beschreibungen der folgenden Ausführungsbeispiele beschränken sich dabei auf die Erweiterungen und/oder Modifikationen der Laserlichtquelle gemäß der Figuren 1A bis 1F. Ohne Beschränkung wird rein beispielhaft für die folgenden Ausführungsbeispiele eine kohärente erste elektromagnetische Strahlung und eine inkohärente zweite elektromagnetische Strahlung mit einem ersten bzw. zweiten Wellenlängenbereich angenommen, die eine mittlere Wellenlänge von etwa 450 nm aufweisen. Die kohärente erste elektromagnetische Strahlung und die inkohärente zweite elektromagnetische Strahlung weisen damit rein beispielhaft in den folgenden Ausführungsbeispielen jeweils einen blauen Wellenlängenbereich auf.

In Figur 3A ist ein Beispiel für eine Laserlichtquelle mit einer Filterstruktur 5 gezeigt. Die Filterstruktur 5 weist dabei ein erstes Filterelement 6 auf, das großflächig direkt auf der gesamten Strahlungsauskoppelfläche 12 und damit insbesondere auf dem ersten und zweiten Teilbereich 121 und 122 gemäß Figur 1F aufgebracht ist.

Das erste Filterelement 5 weist dabei einen Schichtenstapel mit einer Antimon-haltigen Schicht zwischen zwei Siliziumnitrid-Schichten auf. Wie im allgemeinen Teil beschriebenen weist ein derartiger Schichtenstapel eine temperaturabhängige Durchlässigkeit für elektromagnetische Strahlung auf, da mittels einer temperaturabhängigen atomaren und/oder molekularen Nahordnung etwa über Oberflächenplasmonenresonanzen elektromagnetische Strahlung unterhalb einer Grenztemperatur des ersten Filterelements und damit einer Grenzintensität einer elektromagnetischen Strahlung nicht-transparent für elektromagnetische Strahlung zu sein. Das erste Filterelement 6 ist dabei derart ausgeführt, dass die zweite Intensität der inkohärenten zweiten elektromagnetischen Strahlung 52 das erste Filterelement 6 lediglich auf eine Temperatur unterhalb der Grenztemperatur aufwärmen kann. Wie in Figur 3A angedeutet wird die inkohärente zweite elektromagnetische Strahlung 52 daher vom ersten Filterelement 6 nicht transmittiert. Die erste Intensität der kohärente erste elektromagnetische Strahlung 51 jedoch ist ausreichend, um das erste Filterelement 6 in dem Filterbereich über dem ersten Teilbereich 121 (siehe Figur 1F) auf eine Temperatur über der Grenztemperatur zu erwärmen. Dadurch ist das erste Filterelement nur in diesem Filterbereich transparent, so dass die kohärente erste elektromagnetische Strahlung 51 von der Laserlichtquelle abgestrahlt werden, ohne dass inkohärente zweite elektromagnetische Strahlung vom zweiten Teilbereich von der Laserlichtquelle in Abstrahlrichtung abgestrahlt werden kann.

Alternativ oder zusätzlich kann das erste Filterelement 6 auch ein sättigbares Halbleitermaterial aufweisen, das wie im allgemeinen Teil beschrieben eine intensitätsabhängige Durchlässigkeit für elektromagnetische Strahlung aufweist.

In Figur 3B ist eine Laserlichtquelle mit einer Filterstruktur 5 gezeigt, die ein erstes Filterelement 6 mit einem Wellenlängenkonversionsstoff aufweist. Der Wellenlängenkonversionsstoff wandelt dabei inkohärente zweite elektromagnetische Strahlung 52 in elektromagnetische Strahlung mit einem dritten Wellenlängenbereich 53 um. Der dritte Wellenlängenbereich umfasst dabei einen roten Wellenlängenbereich. Dabei weist das erste Filterelement mit dem Wellenlängenkonversionsstoff ein intensitätsabhängiges Sättigungsverhalten auf, so dass die kohärente erste elektromagnetische Strahlung 51 das erste Filterelement 6 bis auf geringe Konversionsverluste passieren kann.

Die Filterstruktur 5 weist weiterhin ein drittes Filterelement 8 auf, das als separates Bauelement dem ersten Filterelement 6 in Abstrahlrichtung nachgeordnet ist und das ein Farbfilter für rotes Licht umfasst. Das Farbfilter für rotes Licht ist dabei in dem gezeigten Beispiel ein absorptives Filter, das im roten Wellenlängenbereich nicht-transparent ist. Dadurch kann zwar die blaue kohärente erste elektromagnetische Strahlung 51 durch das dritte Filterelement 8 transmittiert werden, die elektromagnetische Strahlung mit dem dritten Wellenlängenbereich 53 in einem roten Wellenlängenbereich wird jedoch vom dritten Filterelement 8 absorbiert und kann nicht mehr von der Laserlichtquelle abgestrahlt werden. Dadurch kann die Abstrahlung der inkohärenten zweiten elektromagnetischen Strahlung reduziert werden.

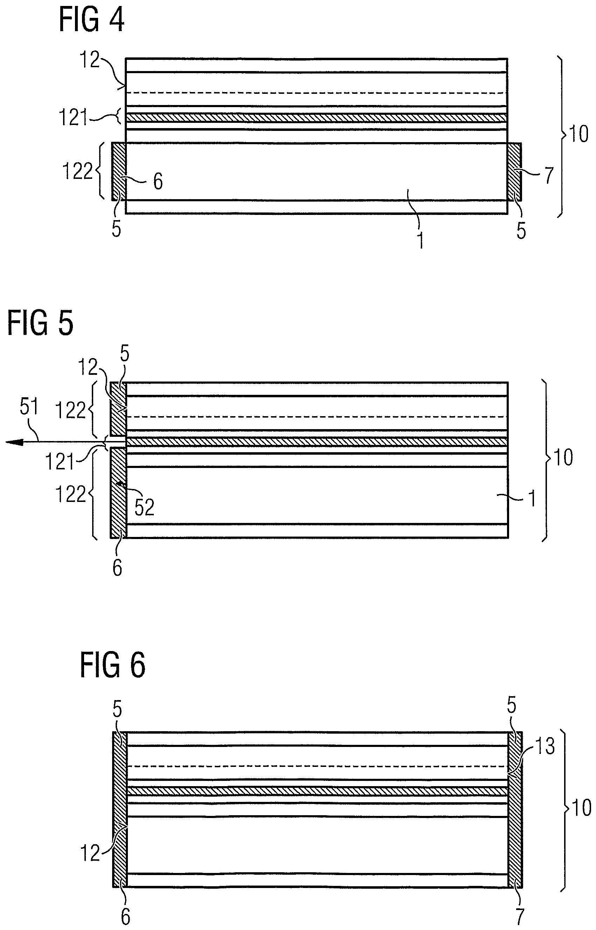

In Figur 4 ist ein Ausführungsbeispiel für eine Laserlichtquelle mit einer Filterstruktur 5 gezeigt. Die Filterstruktur 5 weist dabei ein erstes Filterelement 6 auf einer einen Teil des zweiten Teilbereichs 122 bildenden Oberfläche des Substrats 1 auf. Das erste Filterelement weist dazu eine absorbierende Schicht auf, die Silizium aufweist und nicht-transparent für die inkohärente zweite elektromagnetische Strahlung 52 ist. Dadurch kann die Abstrahlung der inkohärenten zweiten elektromagnetischen Strahlung 52 durch die von der Strahlungsauskoppelfläche 12 umfassten Oberfläche der Strahlungsauskoppelfläche 12 verhindert werden.

Zusätzlich weist die Filterstruktur 5 auf einer der Strahlungsauskoppelfläche 12 gegenüberliegenden Oberfläche des Substrats ein zweites Filterelement 7 auf, das wie das erste Filterelement 6 ausgeführt ist. Zusätzlich kann die Lochblende durch großflächiges Aufbringen der Metallschicht und anschließendes photothermisches Verdampfen des nicht-transparenten Materials über dem ersten Teilbereich 121 herstellbar sein. Insbesondere kann dabei, wie im allgemeinen Teil ausgeführt, die kohärente erste elektromagnetische Strahlung 51 der Halbleiterschichtenfolge 10 selbst eingesetzt werden.

Alternativ zu einer Lochblende mit einer Öffnung wie im gezeigten Ausführungsbeispiel kann das erste Filterelement 6 auch über dem ersten Teilbereich 121 eine transparente Metalloxid- oder Metallnitrid- oder Metalloxinitridschicht aufweisen, die wie im allgemeinen Teil beschrieben durch eine photochemische Reaktion der vorher großflächig aufgebrachten Metallschicht herstellbar ist.

In Figur 6 ist ein weiteres Beispiel für eine Laserlichtquelle gezeigt, die eine Filterstruktur 5 mit einem ersten Filterelement 6 auf der Strahlungsauskoppelfläche 12 und einem zweiten Filterelement 7 auf der der Strahlungsauskoppelfläche 12 gegenüberliegenden Oberfläche der Halbleiterschichtenfolge 10, das heißt der Rückseite 13, aufweist. Die Filterelemente 6 und 7 sind dabei jeweils als Filterelemente mit einer wellenlängen- und winkelabhängigen Durchlässigkeit in Form von Bragg-Spiegeln ausgeführt. Insbesondere ist die Filterstruktur 5 im gezeigten Ausführungsbeispiel als Teil des optischen Resonators der Halbleiterschichtenfolge 10 ausgebildet.

Dabei weist das erste Filterelement 6 eine hohe Reflektivität für inkohärente zweite elektromagnetische Strahlung auf, die mit einem Winkel 91 größer einem Grenzwinkel von Strahlungsauskoppelfläche 12 abgestrahlt wird. Das zweite Lochblende durch großflächiges Aufbringen der Metallschicht und anschließendes photothermisches Verdampfen des nicht-transparenten Materials über dem ersten Teilbereich 121 herstellbar sein. Insbesondere kann dabei, wie im allgemeinen Teil ausgeführt, die kohärente erste elektromagnetische Strahlung 51 der Halbleiterschichtenfolge 10 selbst eingesetzt werden.

Alternativ zu einer Lochblende mit einer Öffnung wie im gezeigten Ausführungsbeispiel kann das erste Filterelement 6 auch über dem ersten Teilbereich 121 eine transparente Metalloxid- oder Metallnitrid- oder Metalloxinitridschicht aufweisen, die wie im allgemeinen Teil beschrieben durch eine photochemische Reaktion der vorher großflächig aufgebrachten Metallschicht herstellbar ist.

In Figur 6 ist ein weiteres Ausführungsbeispiel für eine Laserlichtquelle gezeigt, die eine Filterstruktur 5 mit einem ersten Filterelement 6 auf der Strahlungsauskoppelfläche 12 und einem zweiten Filterelement 7 auf der der Strahlungsauskoppelfläche 12 gegenüberliegenden Oberfläche der Halbleiterschichtenfolge 10, das heißt der Rückseite 13, aufweist. Die Filterelemente 6 und 7 sind dabei jeweils als Filterelemente mit einer wellenlängen- und winkelabhängigen Durchlässigkeit in Form von Bragg-Spiegeln ausgeführt. Insbesondere ist die Filterstruktur 5 im gezeigten Ausführungsbeispiel als Teil des optischen Resonators der Halbleiterschichtenfolge 10 ausgebildet.

Dabei weist das erste Filterelement 6 eine hohe Reflektivität für inkohärente zweite elektromagnetische Strahlung auf, die mit einem Winkel 91 größer einem Grenzwinkel von Strahlungsauskoppelfläche 12 abgestrahlt wird. Das zweite Filterelement 7 hingegen weist eine niedrige Reflektivität für inkohärente zweite elektromagnetische Strahlung auf, die mit einem Winkel größer einem Grenzwinkel durch die Halbleiterschichtenfolge 10 auf die Rückseite 13 eingestrahlt wird. Zusätzlich oder alternativ zu einem Bragg-Spiegel kann das erste Filterelement 6 auch ein Etalon aufweisen.

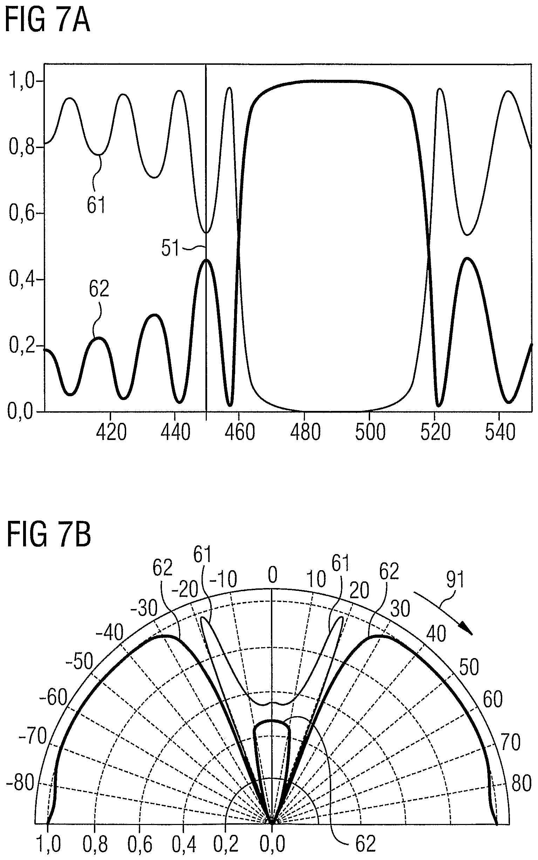

In den Figuren 7A bis 9B sind Beispiele für geeignete als Bragg-Spiegel ausgeführte erste und zweite Filterelemente 6, 7 gezeigt. Alle in diesen Ausführungsbeispielen gezeigten Ausführungen für erste und zweite Filterelement 6 und 7 sind dabei rein beispielhaft für den oben erwähnten ersten beziehungsweise zweiten Wellenlängenbereich um eine mittlere Wellenlänge von etwa 450 nm herum optimiert. Die mittlere Wellenlänge der kohärenten ersten elektromagnetischen Strahlung 51 ist in den Figuren 7A, 7C, 8A und 9A durch eine vertikale, mit 51 gekennzeichnete Linie markiert. Die in den Figuren 7A, 7C, 8A und 9A gezeigten wellenlängenabhängigen Durchlässigkeiten 61 beziehungsweise Reflektivitäten 62 entsprechen einem Abstrahlwinkel von 0°, also entlang der Abstrahlrichtung in Figur 1D. Dabei ist auf der horizontalen Abszisse die Wellenlänge in Nanometer und auf der vertikalen Ordinate die Durchlässigkeit bzw. die Reflektivität in beliebigen Einheiten normiert aufgetragen. Die Figuren 7B, 7D, 8B und 9B zeigen winkelabhängige Durchlässigkeiten 61 beziehungsweise Reflektivitäten 62 bei dieser Wellenlänge. Dabei sind jeweils in Polarkoordinaten die winkelabhängige Durchlässigkeit 61 und Reflektivität 62 in beliebigen normierten Einheiten als radiale Koordinate und der Abstrahlwinkel 91 als Winkelkoordinate von -90° bis +90° aufgetragen.

Die Figuren 7A und 7B beziehen sich dabei auf ein erstes Filterelement 6, das einen Bragg-Spiegel mit 20 Schichtenpaaren aufweist. Ein Schichtenpaar umfasst dabei eine erste Schicht mit einem Brechungsindex von ni=l,8 und einer Dicke von λ_{D}/4n₁ sowie eine zweite Schicht mit einem Brechungsindex n₂=2,1 und einer Dicke λ_{D}/4n₂, wobei λ_{D}=487 nm die so genannte Design-Wellenlänge ist. Die ersten und zweiten Schichten der Schichtenpaare können dabei in diesem sowie in den weiteren Beispielen aus Materialien oder Materialkombinationen wie oben im allgemeinen Teil beschrieben gebildet sein, die die entsprechenden Brechungsindizes aufweisen.

Der derart ausgeführte Bragg-Spiegel weist in Abstrahlrichtung, also bei einem Abstrahlwinkel von 0° für die mittlere Wellenlänge von 450 nm der kohärenten ersten elektromagnetischen Strahlung eine Reflektivität von 46% auf. Über einem Grenzwinkel von etwa 30° weist der Bragg-Spiegel eine Reflektivität von mehr als 95% auf, so dass insbesondere inkohärente zweite elektromagnetische Strahlung, die unter einem Winkel 91 größer oder gleich dem Grenzwinkel von der Strahlungsauskoppelfläche abgestrahlt wird, vom ersten Filterelement 6 nicht transmittiert werden kann. Ebenso gilt dies für Winkel, die kleiner oder gleich dem negativen Grenzwinkel sind.

Dabei ist das erste Filterelement 6 derart ausgeführt, dass der erste Wellenlängenbereich der kohärenten ersten elektromagnetischen Strahlung 51 einem ersten lokalen Nebenmaximum auf der kurzwelligen Seite des globalen Hauptmaximums der Reflektivität 62 entspricht. Da die Reflektivität 62 in Abstrahlrichtung für Wellenlängen in ein einem Bereich von etwa ± 5 nm um die mittlere Wellenlänge der kohärenten ersten elektromagnetischen Strahlung 51 herum daher geringer ist, schwingt im aktiven Bereich 45 bevorzugt die mittlere Wellenlänge der kohärenten ersten elektromagnetischen Strahlung 51 an und das erste Filterelement 6 kann somit auch eine Wellenlängenstabilisierung der kohärenten ersten elektromagnetischen Strahlung 51 ermöglichen.

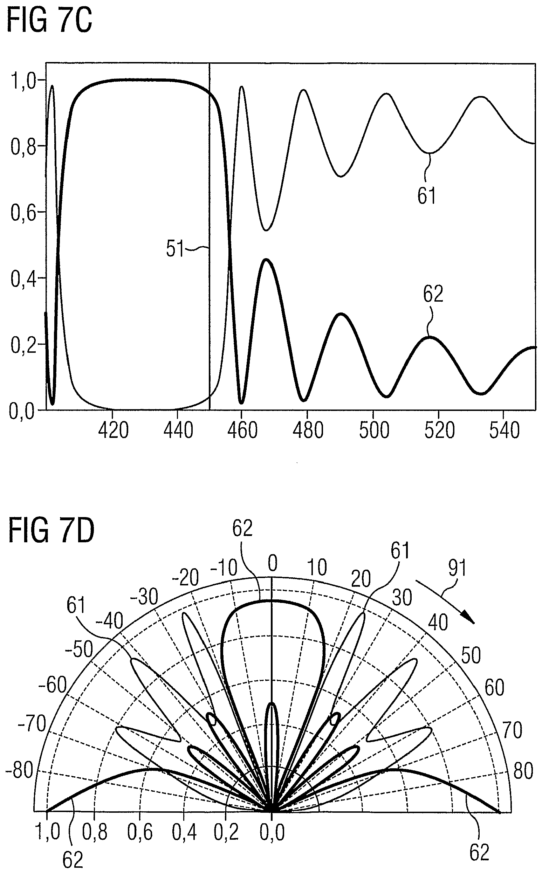

Die Figuren 7C und 7D beziehen sich dabei auf ein zweites Filterelement 7, das dem Schichtaufbau des ersten Filterelements 6 aus den Figuren 7A und 7B entspricht, wobei für das zweite Filterelement 7 die Design-Wellenlänge λ_{D}=429 nm gewählt wurde. Dadurch weist das zweite Filterelement 7 eine geringe Transmittivität 61 von etwa 5% beziehungsweise eine hohe Reflektivität 62 von etwa 95% für die mittlere Wellenlänge der kohärenten ersten elektromagnetischen Strahlung 51 parallel zur Abstrahlrichtung auf. Für Winkel 91 größer als ein Grenzwinkel von etwa 20° beziehungsweise kleiner als etwa -20° hingegen weist das zweite Filterelement 7 eine hohe Transmittivität 61 auf, so dass inkohärente zweite elektromagnetische Strahlung 52, die unter einem derartigen Winkel auf die Rückseite 13 der Halbleiterschichtenfolge eingestrahlt wird, vom zweiten Filterelement 7 transmittiert und aus der Halbleiterschichtenfolge 10 entfernt werden kann werden kann und somit nicht mehr in Abstrahlrichtung über die Strahlungsauskoppelfläche 12 abgestrahlt werden kann.

Der Bragg-Spiegel für das zweite Filterelement 7 ist dabei so ausgeführt, dass der erste Wellenlängenbereich der kohärenten ersten elektromagnetischen Strahlung 51 nahe der langwelligen Kante des globalen Hauptmaximums der Reflektivität 62 liegt, insbesondere innerhalb der langwelligen 30% des Bereichs, der durch das globale Hauptmaximum überdeckt wird.

Dadurch, dass parallel zur Abstrahlrichtung, also unter einem Winkel von 0°, die Reflektivität 62 des zweiten Filterelements 7 für Wellenlängen größer als die mittlere Wellenlänge der kohärenten ersten elektromagnetischen Strahlung 51 geringer ist und für Wellenlängen kleiner als die die mittlere Wellenlänge der kohärenten ersten elektromagnetischen Strahlung 51 nahezu gleich der Reflektivität bei der mittleren Wellenlänge ist, kann auch durch das zweite Filterelement 7 eine Wellenlängenstabilisierung der kohärenten ersten elektromagnetischen Strahlung 51 ermöglicht werden.

Die aus den Filterelementen 6 und 7 gemäß der Figuren 7A bis 7D gebildete Filterstruktur 5 ermöglich somit eine Reduzierung der in Abstrahlrichtung über die Strahlungsauskoppelfläche abgestrahlten inkohärenten zweiten elektromagnetischen Strahlung 52 sowie gleichzeitig eine Wellenlängenstabilisierung des ersten Wellenlängenbereichs der kohärenten ersten elektromagnetischen Strahlung 51. die Wellenlängenstabilisierung kann damit auch eine Verbesserung der Farbwiedergabe der Laserlichtquelle ermöglichen und den Farbabgleich mehrerer Laserlichtquellen vereinfachen.

Alternativ zu dem in dem in Verbindung mit den Figuren 7C und 7D beschriebenen zweiten Filterelement 7 kann dieses auch beispielsweise 8 Schichtenpaare mit abwechselnden Brechungsindizes von 1,5 und 2,1 aufweisen. Dadurch lässt sich ein ähnliche Wellenlänge- und Winkelabhängigkeit der Reflektivität 62 und der Durchlässigkeit 61 erreichen. Weiterhin kann der Schichtenstapel des Bragg-Spiegels anstatt der Schichtenpaare mit zwei Schichten beispielsweise auch Schichtenmultipletts mit jeweils drei oder mehr Schichten mit unterschiedlichen Brechungsindizes aufweisen.

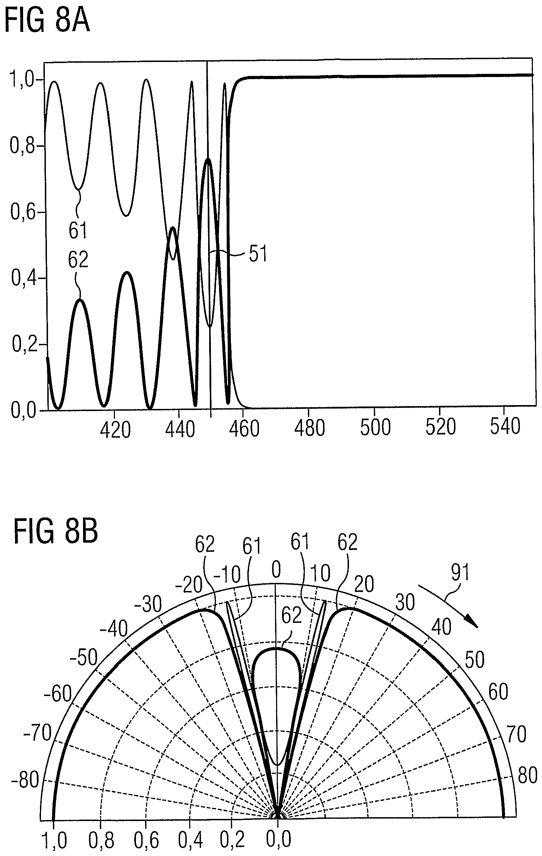

Die Figuren 8A und 8B beziehen sich dabei auf ein weiteres erstes Filterelement 6 mit einem Bragg-Spiegel. Durch Änderung der Anzahl der Schichtenpaare und/oder Änderung des Brechungsindex-Unterschieds zwischen den Schichten der Schichtenpaare können die wellenlängen- und winkelabhängige Durchlässigkeit 61 und Reflektivität 62 weiter angepasst werden. Der Bragg-Spiegel mit den Durchlässigkeiten 61 und Reflektivitäten 62 der Figuren 8A und 8B weist etwa 20 Schichtenpaare mit Brechungsindizes von 1,5 und 2,1 auf, wodurch der Grenzwinkel auf etwa 15° verringert werden kann, so dass inkohärente zweite elektromagnetische Strahlung 52, die unter einem Winkel größer als der Grenzwinkel eine Reflektivität von mehr als 90% erfährt. Dadurch kann die inkohärente zweite elektromagnetische Strahlung 52 in einem großen Winkelbereich nicht von der Strahlungsauskoppelfläche abgestrahlt werden.

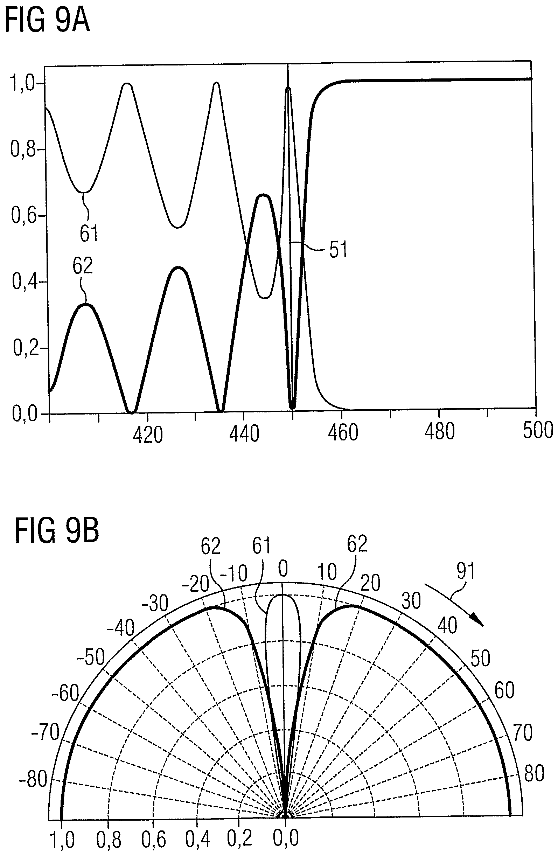

Die Figuren 9A und 9B beziehen sich dabei auf ein weiteres erstes Filterelement 6 mit einem Bragg-Spiegel mit 15 Schichtenpaaren und Brechungsindizes der ersten und zweiten Schichten der Schichtenpaare von 1,5 und 2,1. Dabei wurde für die Dicke der Schichten eine Design-Wellenlänge von 505,4 nm gewählt. Der derart ausgeführte Bragg-Spiegel hat in Abstrahlrichtung für die mittlere Wellenlänge der kohärenten ersten elektromagnetischen Strahlung 51 eine Durchlässigkeit 61 von nahezu 100%, wohingegen die Durchlässigkeit für Abstrahlungswinkel 91, die von der Abstrahlrichtung abweichen, und für Wellenlängen, die von der mittleren Wellenlänge abweichen, sehr rasch abfällt und die Reflektivität 62 dementsprechend ansteigt. Insbesondere entspricht das erste lokale Maximum der Durchlässigkeit 61 auf der kurzwelligen Seite des globalen Maximums dem ersten Wellenlängenbereich der kohärenten ersten elektromagnetischen Strahlung 51.

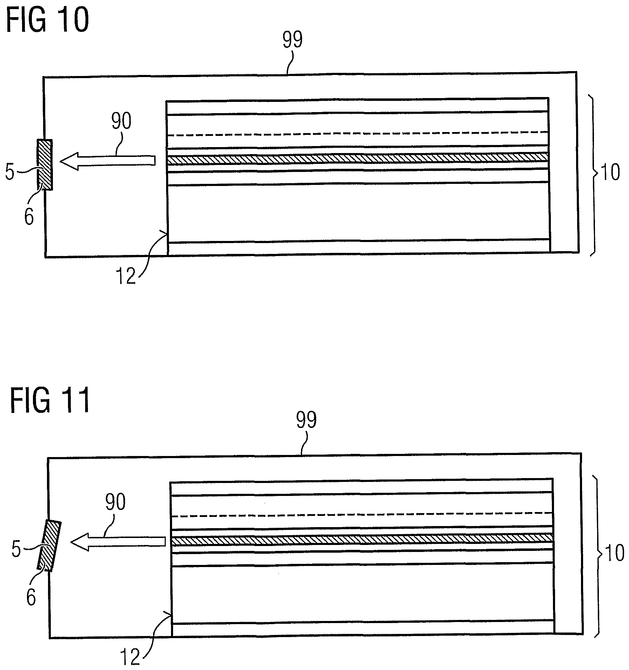

Der Bragg-Spiegel gemäß der Figuren 9A und 9B ist insbesondere für ein separat zur Halbleiterschichtenfolge 10 angeordnetes erstes Filterelement 6 geeignet. Beispielsweise kann es sich dabei um ein entspiegeltes Fenster eines Gehäuses 99 handeln, in dem die Halbleiterschichtenfolge 10 angeordnet ist, wie in Figur 10 gezeigt ist. Die Filterstruktur 5 kann dabei wie im gezeigten Beispiel lediglich das erste Filterelement 5 als Gehäusefenster umfassen. Alternativ oder zusätzlich dazu kann die Filterstruktur 5 weitere erste, zweite und dritte Filterelemente 6, 7 und 8 gemäß der vorherigen Beispiele als separate oder direkt auf die Halbleiterschichtenfolge 10 aufgebrachte Bauelemente oder Schichten aufweisen.

In Figur 11 ist die als Gehäusefenster eines Gehäuses 99 ausgeführte Filterstruktur 5 ein zur Abstrahlrichtung 90 verkipptes erstes Filterelement 6 auf. Durch eine derartige Verkippung, etwa um einen Winkel kleiner oder gleich 10°, kann verhindert werden, dass vom ersten Filterelement 6 reflektierte elektromagnetische Strahlung zurück in die Halbleiterschichtenfolge 10 fällt, wodurch die Stabilität der Emission der kohärenten ersten elektromagnetischen Strahlung 51 erhöht werden kann.

Zusätzlich zu den Filterelementen der bisher beschriebenen Filterstrukturen 5 kann eine Filterstruktur 5 ein viertes Filterelement 9 gemäß den folgenden Ausführungsbeispielen aufweisen.

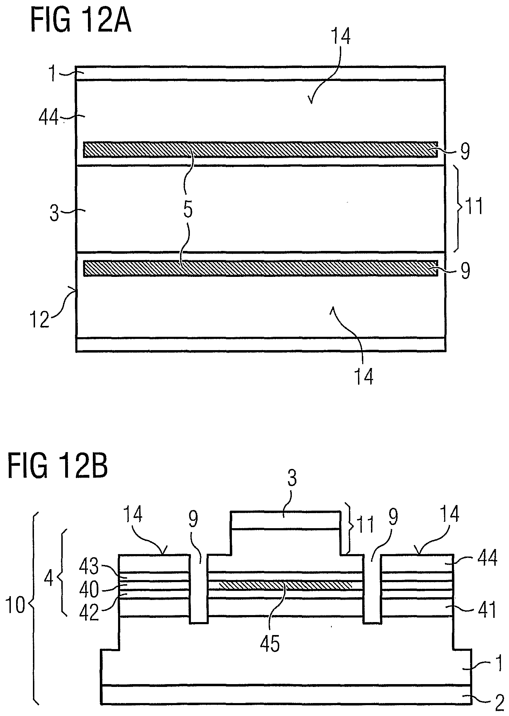

In den Figuren 12A und 12B ist ein Ausführungsbeispiel für eine Laserlichtquelle in einer Draufsicht gemäß Figur 1C und einer Schnittansicht gemäß Figur 1B gezeigt. Die Filterstruktur 5 weist eine Oberflächenstruktur als viertes Filterelement 9 in Form von zwei parallel der Ridge-Struktur 11 verlaufenden Gräben auf. Die Oberflächenstruktur ist dabei in der dem Substrat 1 abgewandten Oberfläche 14 der Halbleiterschichtenfolge 10 seitlich bzw. lateral versetzt zum aktiven Bereich 45 aufgebracht. Die Gräben sind etwa 1 bis 4 µm beabstandet zur Ridge-Struktur 11 angeordnet und reichen durch die funktionalen Schichten 4 hindurch bis in das Substrat 1. Dadurch kann eine Wellenleitung von inkohärenter zweiter elektromagnetischer Strahlung 52 aus dem aktiven Bereich zu den Seitenflächen der Halbleiterschichtenfolge 10 in Richtung der Erstreckungsebene der funktionalen Schichten verhindert werden. Insbesondere können die Flächen der Gräben mit einem absorbierenden, nicht-transparenten Material wie etwa Chrom und/oder Germanium beschichtet sein oder die Gräben mit einem absorbierenden, nicht-transparenten Material gefüllt sein.

Die Gräben im gezeigten Ausführungsbeispiel verlaufen über nahezu die gesamte Länge der Halbleiterschichtenfolge 10. Alternativ können die Gräben auch in nur einem Teilbereich der Halbleiterschichtenfolge 10 verlaufen.

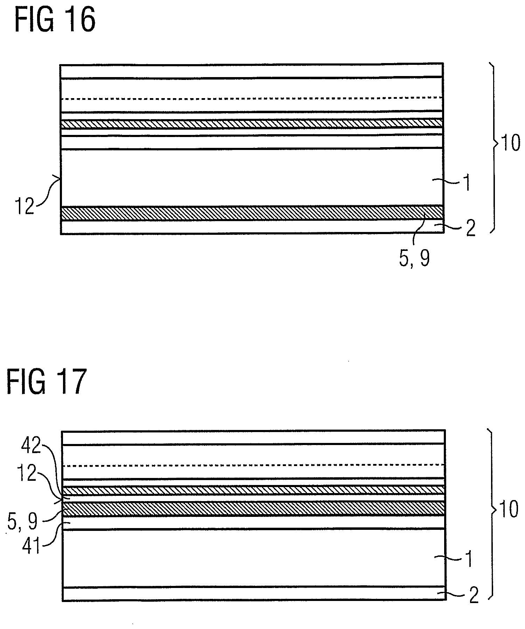

Im gezeigten Ausführungsbeispiel sind die Seitenflächen der Gräben senkrecht zur Erstreckungsrichtung der Halbleiterschichtenfolge ausgebildet. Weiterhin können die Seitenflächen der Gräben angeschrägt sein und mit der Aufwachsrichtung der Halbleiterschichtenfolge 10 einen Winkel von größer als 0° und kleiner oder gleich 45° einschließen. Damit können die Gräben einen U-förmigen oder einen V-förmigen Querschnitt oder eine Kombination daraus aufweisen. Durch angeschrägte Seitenflächen kann es möglich sein, dass zumindest ein Teil der inkohärenten zweiten elektromagnetischen Strahlung 52 aus der aktiven Schicht 40, die sich entlang der Erstreckungsebene der Halbleiterschichtenfolge 10 ausbreitet, in Richtung des Substrat 1 reflektiert werden kann. In Verbindung mit derartig angeschrägten Gräben kann eine absorbierende oder aufgeraute Schicht gemäß der Ausführungsbeispiele der Figuren 16 und 17 die weitere Ausbreitung von inkohärenter zweiter elektromagnetischer Strahlung 52 in der Halbleiterschichtenfolge 10 und damit auch eine Abstrahlung über die Strahlungsauskoppelfläche 12 in Abstrahlrichtung verhindern oder zumindest verringern. Weiterhin kann auch das Substrat 1 nicht-transparent und zumindest teilweise absorbierend ausgeführt sein.

Die Gräben können beispielsweise durch Ätzen herstellbar sein. Um eine mögliche Degradation des aktiven Bereichs zu vermeiden, kann es im alternativ zum gezeigten Ausführungsbeispiel auch vorteilhaft sein, wenn nur gerade so tief geätzt wird, dass keine Wellenleitung zwischen den Wellenleiterschichten 42 und 43 mehr möglich ist, die aktive Schicht 40 aber möglichst nicht durchgeätzt wird.

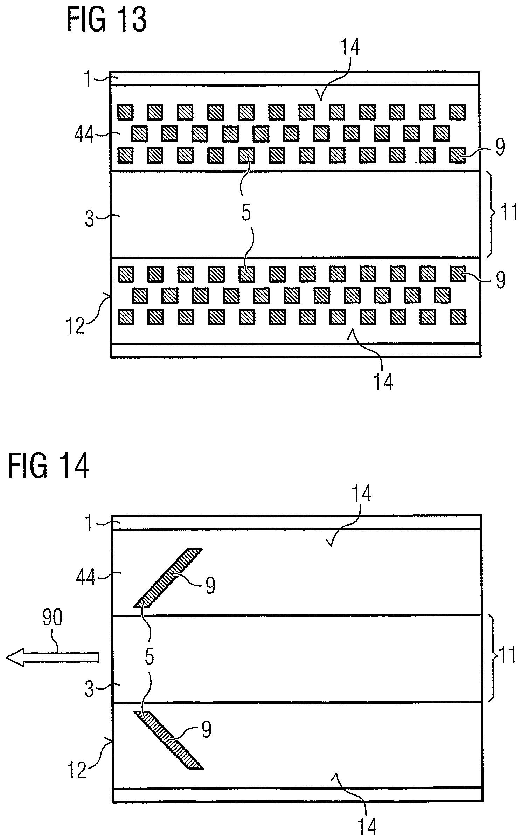

In Figur 13 ist eine Laserlichtquelle mit einer Filterstruktur 5 gezeigt, die als viertes Filterelement 9 mehrere regelmäßige, parallel zur Ridge-Struktur 11 verlaufende Anordnungen von Vertiefungen anstelle der Gräben im vorhergehenden Ausführungsbeispiel aufweist. Die Vertiefungen weisen dabei Durchmesser und Abstände zueinender auf, die kleiner oder gleich dem zweiten Wellenlängenbereich der inkohärenten zweiten elektromagnetischen Strahlung 52 ist. Dadurch kann das vierte Filterelement 9 entlang der Erstreckungsebene der Halbleiterschichtenfolge 10 als photonischer Kristall wirken. Die Vertiefungen des vierten Filterelements 9 weisen im gezeigten Ausführungsbeispiel quadratische Querschnitte auf. Alternativ oder zusätzlich können Vertiefungen auch beispielsweise auch kreis-, ellipsen-, rechtecks- oder sechsecksförmige Querschnitte aufweisen. Die Vertiefungen können weiterhin angeschrägte Seitenflächen aufweisen und sich hinsichtlich ihrer Querschnittsfläche in Richtung in die Halbleiterschichtenfolge 10 hinein verkleinern. Alternativ oder zusätzlich kann das vierte Filterelement 9 auch eine Mehrzahl von Gräben aufweisen.

Im Ausführungsbeispiel gemäß Figur 14 weist die Filterstruktur 5 ein viertes Filterelement 9 in Form von unter einem Winkel von etwa 45° zur Abstrahlrichtung 90 verlaufenden Gräben auf. Die Flanken der Gräben können wiederum einen Winkel von 0° bis 45° mit der Aufwachsrichtung der Halbleiterschichtenfolge 10 aufweisen und können beispielsweise mit einem nicht-transparenten, absorbierenden Material beschichtet sein. Der abstand zur Ridge-Struktur 11 beträgt weniger als 4 µm. Durch das in Figur 14 gezeigte vierte Filterelement 9 kann die Auskopplung von inkohärenter zweiter elektromagnetischer Strahlung 52 aus der Strahlungsauskoppelfläche effektiv vermindert werden.

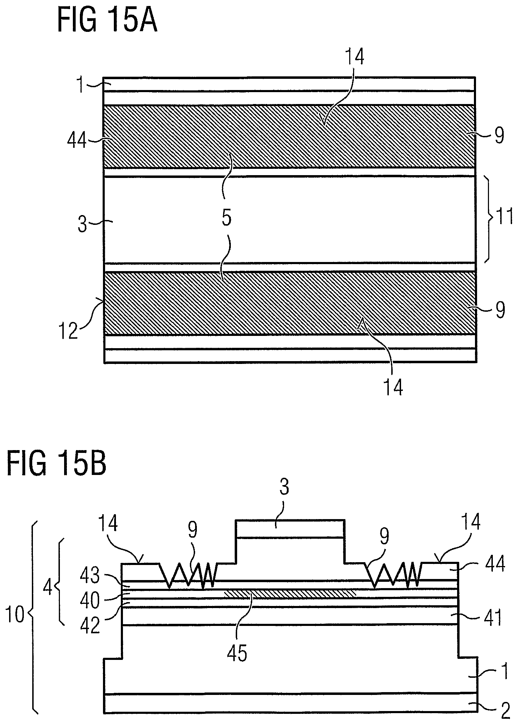

In den Figuren 15A und 15B ist ein viertes Filterelement 9 gezeigt, das eine Oberflächenstruktur in Form einer Aufrauung der Oberfläche 14 aufweist. Die Ausrauung weist dabei eine mittlere Periodizität von etwa einem Zehntel der mittleren Wellenlänge des zweiten Wellenlängenbereichs der inkohärenten zweiten elektromagnetischen Strahlung 52 auf. Die Aufrauung reicht dabei nicht bis unmittelbar an die Ridge-Struktur 11 heran sondern ist einige Mikrometer beabstandet zu dieser. Die Aufrauung, die durch nass- oder trockenchemische Ätzverfahren herstellbar ist, reicht dabei bis in die obere Wellenleiterschicht 43, ohne das die aktive Schicht 40 durchgeätzt wird, um eine Degradation des aktiven Bereichs zu vermeiden. Wie im allgemeinen Teil beschrieben kann auch durch ein derartiges viertes Filterelement 9 die Ausbreitung der inkohärenten zweiten elektromagnetischen Strahlung 52 in Richtung der Erstreckungsebene der Halbleiterschichtenfolge 10 vermindert oder verhindert werden.

Die in den Figuren 12A bis 15B gezeigten vierten Filterelemente 9 können alternativ oder zusätzlich auch auf der dem aktiven Bereich gegenüberliegende Oberfläche des Substrats 1 oder der Mantelschicht 41 angeordnet sein.

In den Figuren 16 und 17 sind weitere Ausführungsbeispiele für vierte Filterelemente 9 gezeigt, die Aufrauungen und/oder eine Schicht mit nicht-transparentem Material an Grenzflächen von Schichten der Schichtenfolge 10 aufweisen.

Dabei ist in Figur 16 beispielhaft ein viertes Filterelement 9 mit einer nicht-transparenten Schicht, die Cr und/oder Ti aufweist, zwischen dem Substrat 1 und der unteren Elektrode 2 gezeigt. Alternativ oder zusätzlich kann auch die Elektrode 2 eine solche Schicht umfassen und damit nicht-transparent ausgeführt sein. Alternativ oder zusätzlich kann das vierte Filterelement 9 auch eine Aufrauung einer Oberfläche der Elektrode 2 und/oder der Substrats 1 aufweisen.

In Figur 17 ist eine nicht-transparente Schicht als viertes Filterelement 9 zwischen der Mantelschicht 41 und der Wellenleiterschicht 42 gezeigt. Die nicht-transparente Schicht des vierten Filterelements 9 weist dazu ein für die inkohärente zweite elektromagnetische Strahlung 52 absorbierendes Halbleitermaterial auf.

Die in den Figuren 16 und 17 rein beispielhaft gezeigten vierten Filterelemente 9 sind insbesondere geeignet, die Ausbreitung der inkohärenten zweiten elektromagnetischen Strahlung 52 innerhalb der Halbleiterschichtenfolge 10 zu verringern und somit auch eine Abstrahlung der inkohärenten zweiten elektromagnetischen Strahlung 52 in Abstrahlrichtung von der Strahlungsauskoppelfläche 12 zu vermindern oder zu verhindern.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Laserlichtquelle, umfassend
- eine Halbleiterschichtenfolge (10) mit einem aktiven Bereich (45) und einer Strahlungsauskoppelfläche (12) mit einem ersten Teilbereich (121) und einem davon verschiedenen zweiten Teilbereich (122), und
- eine Filterstruktur (5),
wobei
- der erste Teilbereich (121) an den aktiven Bereich (45) angrenzt und der zweite Teilbereich (122) Bereiche der Strahlungsauskoppelfläche (12) umfasst, die nicht an den aktiven Bereich (45) angrenzen,
- der aktive Bereich (45) im Betrieb kohärente erste elektromagnetische Strahlung (51) mit einem ersten Wellenlängenbereich und inkohärente zweite elektromagnetische Strahlung (52) mit einem zweiten Wellenlängenbereich erzeugt,
- die kohärente erste elektromagnetische Strahlung (51) entlang einer Abstrahlrichtung (90) vom ersten Teilbereich (121) abgestrahlt wird,
- die inkohärente zweite elektromagnetische Strahlung (52) vom ersten Teilbereich (121) und vom zweiten Teilbereich (122) abgestrahlt wird,
- der zweite Wellenlängenbereich den ersten Wellenlängenbereich umfasst,
- die Filterstruktur (5) die vom aktiven Bereich abgestrahlte inkohärente zweite elektromagnetische Strahlung (52) entlang der Abstrahlrichtung (90) zumindest teilweise abschwächt,
- die Filterstruktur (5) zumindest ein erstes Filterelement (6) umfasst, das der Halbleiterschichtenfolge (10) in Abstrahlrichtung (90) nachgeordnet ist und das nur den zweiten Teilbereich (122) abdeckt,
- die kohärente erste elektromagnetische Strahlung (51) eine erste Intensität aufweist und die inkohärente zweite elektromagnetische Strahlung (52) eine zweite Intensität aufweist, die kleiner als die erste Intensität ist,
- das zumindest eine erste Filterelement (6) eine intensitätsabhängige Durchlässigkeit (61) für elektromagnetische Strahlung aufweist,
**dadurch gekennzeichnet, dass**
- die Durchlässigkeit (61) für elektromagnetische Strahlung des zumindest einen ersten Filterelements (6) ein Sättigungsverhalten aufweist, wobei das erste Filterelement (6) für elektromagnetische Strahlung mit einer Intensität gleich der zweiten Intensität nicht transparent und für eine Intensität größer oder gleich der ersten Intensität transparent ist, so dass das erste Filterelement für die kohärente erste elektromagnetische Strahlung transparent ist, nicht aber für die inkohärente zweite elektromagnetische Strahlung.

2. Laserlichtquelle nach Anspruch 1, wobei
- das zumindest eine erste Filterelement (6) ein Halbleitermaterial mit einer Bandlücke aufweist, die kleiner als die Energie der kohärenten ersten elektromagnetischen Strahlung (51) ist.

3. Laserlichtquelle nach dem vorherigen Anspruch, wobei
- das zumindest eine erste Filterelement (6) zumindest eine Schicht aufweist, die das Halbleitermaterial umfasst.

4. Laserlichtquelle nach Anspruch 2 oder 3, wobei
- das zumindest eine erste Filterelement (6) zwei dielektrische Schichten aufweist, zwischen denen die zumindest eine Schicht mit dem Halbleitermaterial eingebettet ist.

5. Laserlichtquelle nach einem der Ansprüche 2 bis 4, wobei
- die zumindest eine Schicht mit dem Halbleitermaterial ein dielektrisches Matrixmaterial aufweist, in dem das Halbleitermaterial angeordnet ist.

6. Laserlichtquelle nach einem der Ansprüche 1 bis 5, wobei
- das zumindest eine erste Filterelement (6) einen Wellenlängenkonversionsstoff aufweist, der die inkohärente zweite elektromagnetische Strahlung (52) zumindest teilweise in elektromagnetische Strahlung mit einem dritten Wellenlängenbereich (53) umwandelt und
- der dritte Wellenlängenbereich und der zweite Wellenlängenbereich verschieden voneinander sind.

7. Laserlichtquelle nach dem vorherigen Anspruch, wobei
- die Filterstruktur (5) zumindest ein drittes Filterelement (8) aufweist, das dem ersten Filterelement (6) nachgeordnet ist, und
- das dritte Filterelement (8) für die elektromagnetische Strahlung mit dem dritten Wellenlängenbereich (53) nicht transparent ist.

8. Laserlichtquelle nach einem der vorherigen Ansprüche, wobei
- die kohärente erste elektromagnetische Strahlung (51) in einem ersten Filterbereich des zumindest einen ersten Filterelements eine erste Temperatur erzeugt,
- die inkohärente zweite elektromagnetische Strahlung (52) in einem zweiten Filterbereich des zumindest einen ersten Filterelements eine zweite Temperatur erzeugt, die niedriger als die erste Temperatur ist,
- das zumindest eine erste Filterelement (6) eine temperaturabhängige Durchlässigkeit (61) für elektromagnetische Strahlung aufweist und
- das zumindest eine erste Filterelement (6) bis zu einer Temperatur größer oder gleich der zweiten Temperatur nicht transparent ist.

9. Laserlichtquelle nach dem vorherigen Anspruch, wobei
- das zumindest eine erste Filterelement (6) zumindest eine Schicht umfasst, die zumindest ein Element aus einer Gruppe aufweist, die gebildet wird durch: Antimon, Silber, Platin, Palladium und Zink.

## Claims

1. A laser light source, comprising
- a semiconductor layer sequence (10) having an active region (45) and a radiation coupling-out area (12) having a first partial region (121) and a second partial region (122) different than the latter, and
- a filter structure (5),
wherein
- the first partial region (121) adjoins the active region (45) and the second partial region (122) comprises regions of the radiation coupling-out area (12) which do not adjoin the active region (45),
- the active region (45) generates, during operation, coherent first electromagnetic radiation (51) having a first wavelength range and incoherent second electromagnetic radiation (52) having a second wavelength range,
- the coherent first electromagnetic radiation (51) is emitted by the first partial region (121) along an emission direction (90),
- the incoherent second electromagnetic radiation (52) is emitted by the first partial region (121) and by the second partial region (122),
- the second wavelength range comprises the first wavelength range,
- the filter structure (5) at least partly attenuates the incoherent second electromagnetic radiation (52) emitted by the active region along the emission direction (90),
- the filter structure (5) comprises at least one first filter element (6) disposed downstream of the semiconductor layer sequence (10) in the emission direction (90) and covering only the second partial region (122),
- the coherent first electromagnetic radiation (51) has a first intensity and the incoherent second electromagnetic radiation (52) has a second intensity, which is less than the first intensity,
- the at least one first filter element (6) has an intensity dependent transmissivity (61) for electromagnetic radiation,
**characterized in that**
- the transmissivity (61) for electromagnetic radiation of the at least one first filter element (6) has a saturation behavior, wherein the first filter element (6) is non transparent to electromagnetic radiation having an intensity equal to the second intensity and is transparent for an intensity greater than or equal to the first intensity, so that the first filter element is transparent for the coherent first electromagnetic radiation, but not for the incoherent second electromagnetic radiation.

2. The laser light source as claimed in claim 1, wherein
- the at least one first filter element (6) comprises a semiconductor material having a band gap which is smaller than the energy of the coherent first electromagnetic radiation (51).

3. The laser light source as claimed in the preceding claim, wherein
- the at least one first filter element (6) has at least one layer comprising the semiconductor material.

4. The laser light source as claimed in claim 2 or 3, wherein
- the at least one first filter element (6) has two dielectric layers, between which the at least one layer comprising the semiconductor material is embedded.

5. The laser light source as claimed in any of claims 2 to 4, wherein
- the at least one layer comprising the semiconductor material comprises a dielectric matrix material in which the semiconductor material is arranged.

6. The laser light source as claimed in any of claims 1 to 5, wherein
- the at least one first filter element (6) comprises a wavelength conversion substance, which converts the incoherent second electromagnetic radiation (52) at least partly into electromagnetic radiation having a third wavelength range (53), and
- the third wavelength range and the second wavelength range are different from one another.

7. The laser light source as claimed in the preceding claim, wherein
- the filter structure (5) has at least one third filter element (8) disposed downstream of the first filter element (6), and
- the third filter element (8) is non-transparent to the electromagnetic radiation having the third wavelength range (53).

8. The laser light source as claimed in any of the preceding claims, wherein
- the coherent first electromagnetic radiation (51) generates a first temperature in a first filter region of the at least one first filter element,
- the incoherent second electromagnetic radiation (52) generates a second temperature in a second filter region of the at least one first filter element, said second temperature being lower than the first temperature,
- the at least one first filter element (6) has a temperature-dependent transmissivity (61) for electromagnetic radiation, and
- the at least one first filter element (6) is non-transparent up to a temperature greater than or equal to the second temperature.

9. The laser light source as claimed in the preceding claim, wherein
- the at least one first filter element (6) comprises at least one layer comprising at least one element from a group formed by: antimony, silver, platinum, palladium and zinc.

## Revendications

1. Source de lumière laser comportant
- une succession de couches semiconductrices (10) avec une zone active (45) et une surface de découplage du rayonnement (12) avec une première zone partielle (121) et une seconde zone partielle différente de celle-ci (122), et
- une structure à filtre (5),
dans laquelle
- la première zone partielle (121) est adjacente à la zone active (45) et la seconde zone partielle (122) comporte des zones de la surface de découplage du rayonnement (12), qui ne sont pas adjacentes à la zone active (45),
- la zone active (45) génère en fonctionnement un premier rayonnement électromagnétique cohérent (51) avec un premier intervalle de longueur d'onde et un second rayonnement électromagnétique incohérent (52) avec un second intervalle de longueur d'onde,
- le premier rayonnement électromagnétique cohérent (51) est émis le long d'une direction de rayonnement (90) par la première zone partielle (121),
- le second rayonnement électromagnétique incohérent (52) est émis par la première zone partielle (121) et par la seconde zone partielle (122),
- le second intervalle de longueur d'onde comporte le premier intervalle de longueur d'onde,
- la structure à filtre (5) atténue au moins partiellement le second rayonnement électromagnétique incohérent (52) émis par la zone active le long de la direction de rayonnement (90),
- la structure à filtre (5) comporte au moins un premier élément filtrant (6), qui est disposé en aval de la succession de couches semiconductrices (10) dans la direction de rayonnement (90) et qui ne couvre que la seconde zone partielle (122),
- le premier rayonnement électromagnétique cohérent (51) présente une première intensité et le second rayonnement électromagnétique incohérent (52) présente une seconde intensité, qui est inférieure à la première intensité,
- au moins le premier élément filtrant (6) présente une perméabilité (61) au rayonnement électromagnétique en fonction de l'intensité,
**caractérisée en ce que**
- la perméabilité (61) au rayonnement électromagnétique d'au moins le premier élément filtrant (6) présente un comportement de saturation, sachant que le premier élément filtrant (6) est non transparent au rayonnement électromagnétique ayant une intensité égale à la seconde intensité et transparent à une intensité supérieure ou égale à la première intensité, de sorte que le premier élément filtrant est transparent au premier rayonnement électromagnétique cohérent, mais pas au second rayonnement électromagnétique incohérent.

2. Source de lumière laser selon la revendication 1, dans laquelle
- au moins le premier élément filtrant (6) présente une matière de semiconducteur avec une bande interdite, qui est plus petite que l'énergie du premier rayonnement électromagnétique cohérent (51).

3. Source de lumière laser selon la revendication précédente, dans laquelle
- au moins le premier élément filtrant (6) présente au moins une couche qui comporte le matériau de semiconducteur.

4. Source de lumière laser selon les revendications 2 ou 3, dans laquelle
- au moins le premier élément filtrant (6) présente deux couches diélectriques entre lesquelles est intégrée au moins la couche comportant le matériau de semiconducteur.

5. Source de lumière laser selon une quelconque des revendications 2 à 4, dans laquelle
- au moins la couche comportant le matériau de semiconducteur présente un matériau matriciel diélectrique dans lequel est disposé le matériau de semiconducteur.

6. Source de lumière laser selon une quelconque des revendications 1 à 5, dans laquelle
- au moins le premier élément filtrant (6) présente une substance de conversion de longueur d'ondes, qui convertit au moins partiellement le second rayonnement électromagnétique incohérent (52) en rayonnement électromagnétique avec un troisième intervalle de longueur d'onde (53) et
- le troisième intervalle de longueur d'onde et le second intervalle de longueur d'onde sont différents l'un de l'autre.

7. Source de lumière laser selon la revendication précédente, dans laquelle
- la structure à filtre (5) comporte au moins un troisième élément filtrant (8), qui est disposé en aval du premier élément filtrant (6), et
- le troisième élément filtrant (8) n'est pas transparent au rayonnement électromagnétique avec le troisième intervalle de longueur d'onde (53).

8. Source de lumière laser selon une quelconque des revendications précédentes, dans laquelle
- le premier rayonnement électromagnétique cohérent (51) génère une première température dans une première plage de filtrage d'au moins le premier élément filtrant,
- le second rayonnement électromagnétique incohérent (52) génère une seconde température dans une seconde plage de filtrage d'au moins le premier élément filtrant, qui est inférieure à la première température,
- au moins le premier élément filtrant (6) présente une perméabilité (61) au rayonnement électromagnétique en fonction de la température et
- au moins le premier élément filtrant (6) n'est pas transparent jusqu'à une température supérieure ou égale à la seconde température.

9. Source de lumière laser selon la revendication précédente, dans laquelle
- au moins le premier élément filtrant (6) comporte au moins une couche qui présente au moins un élément issu d'un groupe qui est constitué par : l'antimoine, l'argent, le platine, le palladium et le zinc.
